(19) **Europäisches Patentamt / European Patent Office / Office européen des brevets**

(11) **EP 2 338 064 B1**

(12) **FASCICULE DE BREVET EUROPEEN**

(45) Date de publication et mention de la délivrance du brevet:
**15.08.2018 Bulletin 2018/33**

(21) Numéro de dépôt: **09755958.7**

(22) Date de dépôt: **02.10.2009**

(51) Int Cl.:
*G01R 22/00* *(2006.01)*    *G01R 22/10* *(2006.01)*

(86) Numéro de dépôt international:
**PCT/FR2009/051886**

(87) Numéro de publication internationale:
**WO 2010/037988 (08.04.2010 Gazette 2010/14)**

(54) **PROCEDE ET DISPOSITIF DE DETERMINATION NON INTRUSIVE DE LA PUISSANCE ELECTRIQUE CONSOMMEE PAR UNE INSTALLATION, PAR ANALYSE DE TRANSITOIRES DE CHARGE.**

VERFAHREN UND EINRICHTUNG ZUR NICHTEINDRINGENDEN BESTIMMUNG DES VON EINER INSTALLATION VERBRAUCHTEN ELEKTRISCHEN STROMS DURCH ANALYSIEREN VON LASTTRANSIENTEN

METHOD AND DEVICE FOR THE NON-INTRUSIVE DETERMINATION OF THE ELECTRICAL POWER CONSUMED BY AN INSTALLATION, BY ANALYSING LOAD TRANSIENTS

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **03.10.2008 FR 0856717**

(43) Date de publication de la demande:
**29.06.2011 Bulletin 2011/26**

(73) Titulaires:
- **Electricité de France**
  **75008 Paris (FR)**
- **Université Blaise Pascal Clermont II**
  **63006 Clermont Ferrand Cedex 1 (FR)**
- **Landis + Gyr**
  **03100 Montlucon (FR)**
- **Centre National de la Recherche Scientifique (C.N.R.S.)**
  **75794 Paris Cedex 16 (FR)**

(72) Inventeurs:
- **DIOP, Alioune**
  **F-92600 Asnieres (FR)**
- **JOUANNET, Thierry**
  **F-03100 Montlucon (FR)**
- **EL KHAMLICHI DRISSI, Khalil**
  **F-63800 Cournon D'auvergne (FR)**
- **NAJMEDDINE, Hala**
  **F-63110 Beaumont (FR)**

(74) Mandataire: **Cabinet Plasseraud**
   **66, rue de la Chaussée d'Antin**
   **75440 Paris Cedex 09 (FR)**

(56) Documents cités:
**WO-A-97/25625      US-A- 5 483 153**
**US-B2- 6 816 078**

- **ROOS J G: "NON-INTRUSIVE LOAD MONITORING OF ELECTRICAL OF ELECTRICAL APPLIANCES" ELEKTRON, ELEKTRON VERLAG, AT, vol. 11, no. 4, 1 avril 1994 (1994-04-01), pages 27-30, XP009056124 ISSN: 0374-3098**
- **ZHU Y ET AL: "Spectral estimation of two-dimensional, NMR signals by matrix pencil method" PROCEEDINGS OF THE REGION TEN CONFERENCE (TENCON). BEIJING, OCT. 19 - 21, 1993; [PROCEEDINGS OF THE REGION TEN CONFERENCE (TENCON)], BEIJING, IAP, CN, vol. -, 19 octobre 1993 (1993-10-19), pages 546-549, XP010114122 ISBN: 978-0-7803-1233-3**
- **YINGBO HUA, TAPAN K. SARKAR: "generalized pencil-offunction method for extracting poles of an em system from its transient response" IEEE TRANSACTIONS ON ANTENNAS AND PROPAGATION, vol. 37, no. 2, février 1989 (1989-02), pages 229-234, XP002534413 cité dans la demande**

- COLE A I ET AL: "Data extraction for effective non-intrusive identification of residential power loads" INSTRUMENTATION AND MEASUREMENT TECHNOLOGY CONFERENCE, 1998. IMTC/98. CONFERENCE PROCEEDINGS. IEEE ST. PAUL, MN, USA 18-21 MAY 1998, NEW YORK, NY, USA,IEEE, US, vol. 2, 18 mai 1998 (1998-05-18), pages 812-815, XP010281749 ISBN: 978-0-7803-4797-7

**Description**

L'invention est relative à un procédé et à un dispositif de détermination non intrusive de la puissance électrique consommée par une installation, par analyse de transitoires de charge.

A l'heure actuelle la puissance électrique consommée par une installation d'un client abonné, alimentée par le réseau en tension alternative, et la consommation d'énergie électrique correspondante, sont déterminées à partir de mesures directes des paramètres physiques de l'installation, tels que la tension électrique d'alimentation, l'intensité du courant électrique délivré, le déphasage entre le courant électrique délivré et la tension d'alimentation.

De manière habituelle des modules électroniques permettent, à partir des valeurs de tension, de courant et de déphasage précitées, de calculer la puissance électrique active ou réactive consommée, ainsi que, par intégration de valeurs de puissance successives sur une plage temporelle donnée, l'énergie électrique consommée. Les modules électroniques précités sont le plus souvent implantés dans un appareil de comptage, tel qu'un compteur électronique et peuvent, dans certains cas, procéder à une transmission des valeurs précitées mesurées et/ou des valeurs de puissance ou d'énergie finalement consommée.

Les appareils de comptage précités donnent satisfaction. Toutefois, ils présentent l'inconvénient de nécessiter l'implantation des modules électroniques précités dans les appareils de comptage eux-mêmes, et donc dans le périmètre privé de l'abonné client, c'est-à-dire, le plus souvent, l'habitation de l'abonné.

Différents développements ont été proposés en vue de déporter la mesure et le comptage de la puissance ou de l'énergie hors du périmètre privé de l'abonné client.

Une approche dans ce sens consiste à effectuer une mesure de tension d'alimentation et de courant délivré à l'extérieur du périmètre privé de l'abonné client, par analyse de la courbe de charge globale de l'installation soit au niveau de l'appareil de comptage, soit en amont de ce dernier, sur le branchement de l'installation de l'abonné client, dans le but de mettre en oeuvre des processus non intrusifs, connus sous le nom de NIALM pour Non Intrusive Appliance Load Monitoring en anglais. L'intérêt des processus non intrusifs précités est manifeste pour les fournisseurs, les distributeurs et les consommateurs d'énergie électrique face aux enjeux de prévision de coûts de l'énergie, de développements de réseaux et de réduction des consommations.

Les processus de NIALM font apparaître plusieurs degrés de non intrusion, ceux comportant une étape d'apprentissage automatisé des appareils, décrits par le brevet US 4 858 141, et ceux comportant une étape d'apprentissage manuel des appareils, décrits par le brevet US 5 483 153 par exemple.

Les processus NIALM manuels s'avèrent plus précis que les processus NIALM automatiques, grâce au recueil des signatures de consommation des appareils à différents états de consommation.

Cette semi-intrusion est cependant gênante pour l'abonné client et peu attractive pour le distributeur ou le fournisseur d'énergie électrique.

Dans le cas des processus NIALM manuels, une bibliothèque d'appareils récepteurs électriques est construite, à partir d'un capteur d'intensité de courant électrique sur chaque appareil.

Dans le cas des processus NIALM automatiques une bibliothèque d'appareils récepteurs électriques s'améliorant dans le temps est construite, à partir des puissances mesurées sur l'appareil de comptage.

Les bibliothèques précitées permettent en fait d'identifier chaque appareil électrique et sa consommation et ont favorisé une évolution vers l'identification des usages de ces appareils, voire des habitudes d'usage ou de consommation de ces derniers par les abonnés clients qui en disposent.

Ainsi, différents modes opératoires d'identification des usages ont été proposés :

-  à partir de la reconnaissance de la variation d'intensité du courant, ainsi que décrit dans la demande de brevet FR 2 645 968. Cette variation est comparée à un seuil représentatif d'un événement, enclenchement ou déclenchement d'une charge domestique. Les valeurs de seuil sont répertoriées dans une bibliothèque ;
-  à partir de la mesure des variations de puissance active et réactive et/ou de l'admittance de l'installation en régime permanent, ainsi que décrit par le brevet US 4 858 141. Une comparaison avec une table de référence de différents appareils disponibles sur le marché, mémorisée en bibliothèque est effectuée ;
-  à partir de la mesure du courant à la fréquence fondamentale et de ses harmoniques, ainsi que décrit dans le brevet US 6 816 078. Chaque appareil est identifié par les harmoniques (par transformée fréquentielle FFT) qu'il engendre et classé dans une bibliothèque. Le fonctionnement des appareils électriques est évalué à la valeur vraie par vérification de l'existence des fréquences harmoniques les plus hautes constitutives du courant électrique total ;
-  à partir de la mesure des puissances actives et réactives de l'installation en régime transitoire, tel que décrit dans le brevet US 5 483 153. Une comparaison des formes des transitoires à une base de données est exécutée pour la reconnaissance des charges. L'article "Data Extraction for Effective Non-Intrusive Identification of Residential Power Loads" de A.Cole et A. Albicki, IEEE Instrumentals and Measurement technology conference, Mai 1998, décrit une technique similaire.
-  à partir de l'exploitation de l'impulsion HF d'allumage émise par les appareils électriques reliés au réseau électrique tel que décrit dans les brevets EP 1 136 829 et US 7 078 982 B2. Ce mode opératoire nécessite, le cas échéant, sur chaque appareil à détecter, l'implantation d'un dispositif d'émission de signaux HF sur le réseau public, des récepteurs ou répéteurs pour amplifier les signaux HF. Bien que qualifié de non intrusif, ce mode opératoire nécessite plusieurs séries de mises sous et hors tension des appareils électriques l'un après l'autre, à la première installation du dispositif d'identification ;
- à partir des mesures effectuées, sur le courant et la tension pour déterminer la variation d'impédance des charges de l'installation au cours du temps, ainsi que décrit dans la demande de brevet WO 93/04377. Un tel processus reste toutefois intrusif. Un composant de mémoire de masse doit être périodiquement remplacé dans l'appareil de comptage par un préposé. On peut aussi citer l'article "NON-INTRUSIVE" LOAD MONITORING OF ELECTRICAL APPLIANCES" de ROOS JG, publié le 1er Avril 1994 dans ELEKTRON Verlag, relativement à cette même technique se basant sur une analyse détailler du courant et de la tension de l'impédance totale de charges de l'installation.

L'ensemble des processus précités présente un niveau d'intrusion peu compatible avec une diffusion de masse que représentent les parcs d'appareils domestiques.

Les processus précités utilisent des paramètres et grandeurs plus conformes aux réseaux d'alimentation en tension purement sinusoïdale, telles que puissances apparentes, réactives, actives, valeurs efficaces de courant et de tension, et sont ainsi mis à mal, car peu adaptés, à la diffusion, sur les installations d'abonnés, de plus en plus nombreuses d'appareils électroniques générateurs de perturbations électriques et de bruit, se superposant à la composante fondamentale.

Les processus précités les plus connus pour l'homme de l'art mettent en oeuvre, pour exécuter une décomposition des signaux, un traitement fréquentiel, du type transformée de Fourier rapide, désignée FFT en anglais.

Ce type de traitement nécessite une fenêtre d'observation relativement importante du signal traité, afin d'assurer une discrimination efficace des différentes composantes du signal traité, fréquence fondamentale, à 50 Hz ou 60 Hz, et fréquences harmoniques, en vue d'un traitement satisfaisant des composantes de bruit précitées superposées à la composante fondamentale.

Parallèlement aux méthodes d'analyse purement fréquentielle précitées, par transformée fréquentielle, du type transformée de Fourier, d'autres méthodes théoriques d'analyse de la réponse en transmission en temps réel, de systèmes soumis à un champ électromagnétique variable ont été proposées. Essentiellement développée dans le cadre de l'étude de la réponse de réflecteurs ou d'antennes excités par une onde électromagnétique supposée se propager par ondes planes, une méthode spécifique, désignée méthode du Pencil, a été proposée, laquelle permet, à partir de la réponse transitoire et permanente d'une cible à une excitation électromagnétique rayonnée, de déterminer les pôles et résidus de la réponse précitée par résolution d'un problème généralisé de valeurs propres.

Pour une description d'une approche théorique de la méthode du Pencil précitée, appliquée à une cible formée par un fil conducteur électrique, on pourra utilement se reporter à l'article intitulé « Generalized Pencil-of-Function Method for Extracting Poles of an EM System from its Transient Response » publié par Yingbo Hua et Tapan K. Sarkar membres du Department of Electrical and Computer Engineering, Syracuse University, Syracuse, NY 13344-1240, IEEE TRANSACTIONS ON ANTENNAS AND PROPAGATION, Vol.37, n°3, February 1989, p 229-234. On peut aussi se reporter à l'article intitulé «Spectral estimation of two-dimensional, NMR Signals by matrix pencil method» de ZHO Y et al., BEIJING, OCT. 19-21, 1993, PROCEEPINGS OF THE REGION TEN CONFERENCE (TENCON). Plus récemment, une étude comparative entre les performances comparées de résolution spectrale entre les techniques de traitement fréquentiel, telle que la transformée de Fourier, et la méthode du Pencil, intitulée « Comparison between the Matrix Pencil Method and the Fourier Transform Technique for High Resolution Spectral Estimation » publiée par José Enrique Fernandez del Rio et Tapan K. Sarkar Department of Electrical and Computer Engineering, 121 Link Hall, Syracuse University, Syracuse, New York 13244-1240, Digital Signal Processing 6, 108-125 (1996) Article N°0011, a montré la supériorité de la méthode du Pencil vis-à-vis des méthodes de traitement fréquentiel par transformée de Fourier, en matière de dispersion d'estimation et d'erreur quadratique moyenne, pour un rapport signal à bruit supérieur à une certaine valeur de seuil.

La présente invention a pour objet la mise en oeuvre d'un procédé et d'un dispositif de détermination non intrusive de la puissance électrique consommée par une installation, par analyse de transitoire de charges par la méthode du Pencil, l'installation étant assimilée à une ou plusieurs charges, pouvant présenter des caractéristiques de réponse variables dans le temps, absorbant partiellement et/ou totalement l'énergie électrique délivrée sous forme d'un signal d'excitation électromagnétique par le réseau de distribution.

Le procédé de détermination non intrusive de la puissance électrique consommée par une installation d'abonné, conforme à l'objet de la présente invention, est exécuté à partir d'un échantillonnage périodique des valeurs de tension d'alimentation et de l'intensité du courant électrique délivrés à cette installation pour obtenir un signal de consommation.

Il est remarquable en ce que, à partir des valeurs échantillonnées du signal de consommation, il consiste au moins à grouper ces valeurs échantillonnées sur des fenêtres temporelles d'observation successives, discriminer, sur chaque fenêtre temporelle d'observation courante successive, l'ensemble des pôles et des résidus du signal de consommation par la méthode du Pencil. Un tel ensemble de pôles et résidus est représentatif, sur la fenêtre d'observation courante, d'une combinaison de signatures de charges électriques distinctes incluant au moins des pôles et des résidus déterminés associées à au moins une valeur singulière obtenue par la méthode du Pencil en fonctionnement dans cette installation, calculer sur au moins la durée de la fenêtre d'observation courante, au moins la puissance active consommée par au moins un sous-ensemble des charges électriques en fonctionnement dans l'installation, exprimée comme la somme des puissances actives consommées par chaque charge électrique distinct de ce sous-ensemble vérifiant une fonction de puissance consommée liant ces pôles et résidus.

Le procédé objet de l'invention est également remarquable en ce que pour la puissance active, la fonction de puissance vérifie la relation :

$$P = \sum_{i=1}^{M} \sum_{i'=1}^{M'} R_{ci.} R_{vi'}.e^{\left(S_{ci}+S_{vi'}\right)\left(t_{kd}+\frac{\Delta t}{2}\right)} . \sinh c\left(\left(S_{ci}+S_{vi'}\right)\frac{\Delta t}{2}\right)$$

où $P$ : désigne la puissance active consommée par l'ensemble des charges électriques distinctes $C_i$ de signature $(S_i, R_i, SG_i)$ ;

$S_{ci}$ et $R_{ci}$ : désignent les pôles respectivement les résidus du courant échantillonné délivré à l'installation ;

$S_{vi'}$ et $R_{vi'}$ : désignent les pôles respectivement les résidus de la tension échantillonnée délivrée à l'installation $SG_i$ désignant les valeurs singulières;

$t_{kd}$ : désigne l'instant de début de la fenêtre d'observation de rang $k$;

$\Delta t$ : désigne la durée de la fenêtre d'observation ; $\sinh c(X)$ : désigne la fonction sinus hyperbolique du cardinal de la valeur X, soit

$$\sinh c\left(\left(S_{ci}+S_{vi'}\right)\frac{\Delta t}{2}\right) = \sinh\left(\left(S_{ci}+S_{vi'}\right)\frac{\Delta t}{2}\right) \bigg/ \left(\left(S_{ci}+S_{vi'}\right)\frac{\Delta t}{2}\right)$$

$M$ : désigne le nombre de pôles et résidus observés du courant échantillonné délivré à l'installation ;

$M'$ : désigne le nombre de pôles et résidus observés de la tension échantillonnée délivrée à l'installation.

Le procédé objet de l'invention est également remarquable en ce que la fréquence d'échantillonnage, pour obtenir le signal de consommation, et la durée $\Delta t$ de chaque fenêtre d'observation sont liées par la relation :

$$\Delta t.fe = Nem \geq 2.\left[\sum_{i=1}^{Nc} nci + 2(1 + H)\right]$$

dans laquelle

Nem : désigne le nombre minimum d'échantillons sur la durée de chaque fenêtre d'observations, $Nc$ désigne le nombre observé de charges électriques distinctes de l'installation d'abonné, $nci$ désigne le nombre de pôles de la charge électrique considérée, $H$ désigne le nombre de composantes harmoniques de la fréquence fondamentale de la tension d'alimentation.

Le procédé objet de l'invention est en outre remarquable en ce que, pour une fenêtre d'observation du signal de consommation incluant le régime libre et le commencement du régime forcé d'enclenchement/déclenchement d'une charge, l'enclenchement/déclenchement d'une charge purement résistive est signé par un régime forcé unique, par l'existence, pour la fenêtre d'observation, de deux pôles complexes conjugués à partie réelle nulle et de deux résidus complexes conjugués dans le régime forcé, et par la phase nulle des résidus en régime forcé, l'enclenchement/déclenchement d'une charge résistive et capacitive est signé par un régime libre et un régime forcé distincts, par l'existence, pour la fenêtre d'observation, de deux pôles complexes conjugués à partie réelle nulle et de deux résidus complexes conjugués à partie réelle nulle dans le régime forcé et par un pôle réel et un résidu dans le régime libre, la phase négative du résidu en régime forcé caractérisant la nature globalement capacitive de la charge, l'enclenchement/déclenchement d'une charge résistive et inductive est signé par un régime libre et un régime forcé distincts, par l'existence, pour la fenêtre d'observation, de deux pôles complexes conjugués à partie réelle nulle et de deux résidus complexes conjugués dans le régime forcé et par un pôle réel et un résidu complexe dans le régime libre, la phase positive du résidu caractérisant la nature globalement inductive de la charge.

Le procédé objet de l'invention est enfin remarquable en ce que, pour une fenêtre d'observation du signal de consommation incluant le régime libre et le début du régime forcé d'enclenchement/déclenchement d'une charge, l'enclenchement/déclenchement d'une charge résistive, inductive et capacitive est signé par un régime forcé et un régime libre distincts, par l'existence, en régime forcé, de deux pôles complexes conjugués à partie réelle nulle et de deux résidus complexes conjugués, et, en régime libre, de deux pôles complexes conjugués et deux résidus complexes conjugués, la phase négative du résidu en régime forcé caractérisant la nature globalement capacitive de la charge et la phase positive du résidu en régime forcé caractérisant la nature globalement inductive de la charge.

Le dispositif de détermination non intrusive de la puissance électrique consommée par une installation d'abonné, objet de l'invention, comporte au moins des ressources d'échantillonnage périodique des valeurs de tension d'alimentation et de l'intensité du courant électrique délivrés à cette installation pour obtenir un signal de consommation.

Il est remarquable en ce qu'il comporte en outre au moins un module de calcul de la puissance instantanée délivrée produit des valeurs échantillonnées des valeurs de tension d'alimentation et de l'intensité du courant électrique délivrés, le signal de consommation comportant l'une au moins des valeurs échantillonnées de la tension d'alimentation, de l'intensité du courant électrique délivrés ou de la puissance instantanée délivrée, des ressources de mémorisation et de lecture des valeurs successives du signal de consommation sur au moins une fenêtre d'observation, des ressources d'application, sur le signal de consommation, sur au moins une fenêtre d'observation courante, d'un traitement de filtrage par la méthode du Pencil, pour discriminer, sur cette fenêtre, l'ensemble des pôles et résidus représentatifs d'une combinaison de signatures de charges électriques distinctes incluant au moins les pôles et les résidus associés à au moins une valeur singulière obtenue par la méthode du Pencil en fonctionnement dans l'installation, un module de suivi temporel de la combinaison de signatures et de calcul, sur au moins la durée de la fenêtre d'observation courante, d'au moins la puissance active consommée par au moins un sous-ensemble des charges électriques en fonctionnement dans l'installation, exprimée comme la somme des puissances actives consommées par chaque charge électrique distincte de ce sous-ensemble vérifiant une fonction de puissance consommée liant ces pôles et résidus.

Le dispositif objet de l'invention est en outre remarquable en ce que le module de suivi temporel de la combinaison de signatures et de calcul d'au moins la puissance active consommée par au moins un sous-ensemble de charges électriques comprennent au moins, un module de détection de changement d'état d'enclenchement/déclenchement de charge électrique, un module d'identification des charges électriques enclenchées et/ou déclenchées à partir des signatures de charges électriques, un module de librairie de charges électriques identifiées en relation avec leur signature, un module d'identification des usages de consommation de l'utilisation abonné et de calcul de la consommation, au moins en puissance active.

Le procédé et le dispositif objets de l'invention trouvent application à la gestion non intrusive des installations domestiques ou industrielles d'appareils électriques, à la construction d'appareils de comptage d'énergie électrique consommée, et, plus généralement, à la surveillance et au contrôle des installations électriques d'usagers.

Ils seront mieux compris à la lecture de la description et à l'observation des dessins ci-après dans lesquels :

- la figure la représente, à titre purement illustratif, un organigramme des étapes essentielles permettant la mise en oeuvre du procédé objet de l'invention ;
- la figure 1b représente, à titre illustratif, une variante de mise en oeuvre préférentielle non limitative du procédé objet de l'invention, dans laquelle un choix spécifique de la durée de la fenêtre d'observation peut être effectué en fonction de la fréquence d'échantillonnage du signal de tension et/ou de courant ;
- la figure 2a représente, à titre purement illustratif, un exemple de mise en oeuvre non limitatif d'une étape d'acquisition des signatures de charges observées dans l'installation d'un abonné client ;
- la figure 2b représente, à titre purement illustratif, un exemple de mise en oeuvre non limitatif d'une étape d'identification des charges électriques, à partir de leur signature ;
- la figure 2c représente, à titre purement illustratif, un exemple de mise en oeuvre non limitatif d'exécution d'une étape de suivi de mise en fonctionnement/respectivement hors fonctionnement de chaque charge à partir d'une discrimination de leur signature.
- la figure 3a représente, à titre d'exemple purement illustratif, le schéma électrique d'une installation d'abonné arbitraire permettant de représenter la mise en oeuvre du procédé objet de l'invention sur une telle installation ;
- la figure 3b représente à titre d'exemple les valeurs d'intensité du courant mesuré pour une commutation des charges de l'installation de la figure 3a, par actionnement des interrupteurs T1, T2, T3 et T4 selon le diagramme temporel représenté sur la figure 3b ;
- la figure 3c représente la distribution et le suivi temporel correspondant des valeurs singulières révélées par la méthode du Pencil, lors de la commutation des charges de l'installation représentée en figure 3b ;
- les figures 3d et 3e représentent un chronogramme du suivi temporel des valeurs réelles des pôles respectivement des valeurs imaginaires des pôles, pour la commutation des charges de l'installation représentée en figure 3b ;
- les figures 3f et 3g représentent un chronogramme du suivi temporel des résidus liés au régime forcé respectivement au régime libre pour la commutation des charges de l'installation représentée en figure 3b ;
- les figures 4a et 4b représentent à titre illustratif, un schéma fonctionnel, sous forme d'un schéma blocs, d'un dispositif de détermination non intrusive de la puissance électrique consommée sur une installation, conforme à l'objet de la présente invention.

Une description détaillée des étapes de mise en oeuvre du procédé de détermination sans intrusion de la puissance électrique consommée par une installation, par analyse de transitoires de charge, conforme à l'objet de l'invention sera maintenant donnée en liaison avec la figure la et les figures suivantes.

La mise en oeuvre sans intrusion du procédé et du dispositif objets de l'invention s'entend d'une exécution de mise en oeuvre en totale transparence de fonctionnement vis-à-vis de l'installation de tout client, soit en aval et/ou dans tout dispositif de comptage de ce client, soit en amont de ce dernier.

En référence à la figure la précitée, on considère une installation d'abonné, installation domestique ou industrielle, pour laquelle on dispose de valeurs de tension d'alimentation et de l'intensité du courant électrique délivrées à cette installation, obtenues par échantillonnage périodique, pour obtenir un signal de consommation.

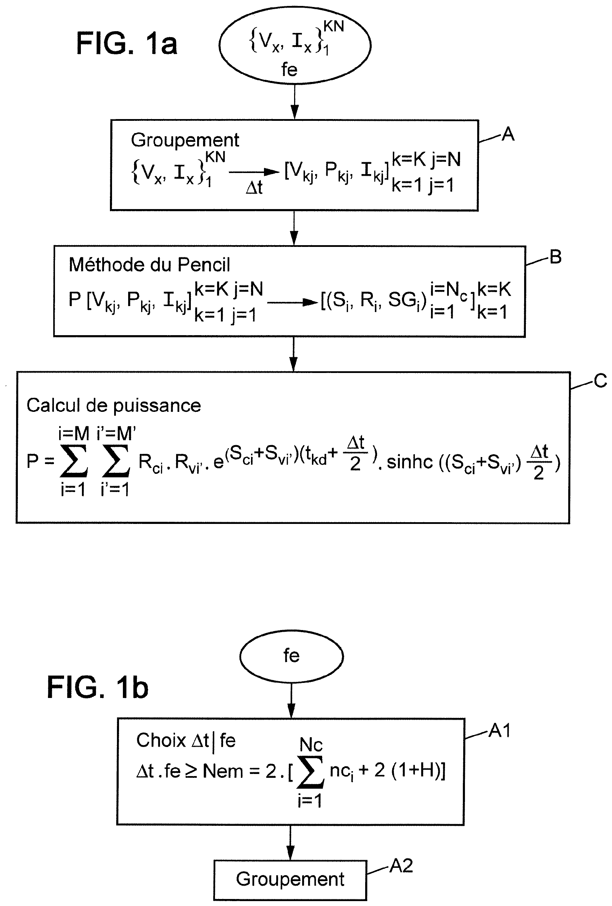

Sur la figure 1a, les valeurs échantillonnées de tension $V_x$ et d'intensité $I_x$ du courant délivré sont notées selon la relation (1):

$$\{V_x, I_x\}_1^{KN}$$

$$fe$$

Dans cette relation, $x$ désigne le rang d'échantillonnage successif des valeurs précitées, $KN$ désigne une valeur finale quelconque du rang d'échantillonnage sur $K$ fenêtres d'échantillonnage successives comportant chacune $N$ échantillons, $fe$ désigne la fréquence d'échantillonnage des valeurs précitées.

Selon un aspect remarquable du procédé objet de l'invention, celui-ci consiste, à partir des valeurs échantillonnées du signal de consommation, en une étape A, à grouper les valeurs échantillonnées précitées sur des fenêtres temporelles d'observation successives.

À l'étape A de la figure 1a, l'opération correspondante est notée selon la relation (2):

$$\{V_x, I_x\}_1^{KN} \rightarrow \left[V_{kj}, P_{kj}\ I_{kj}\right]_{\substack{k=1 \\ j=1}}^{\substack{k=K \\ j=N}}$$

Par l'opération correspondante, on comprend que tout ensemble de valeurs échantillonnées est en fait subdivisé en une pluralité de sous-ensembles de valeurs échantillonnées, chacun constitutif d'une fenêtre d'observation de ces valeurs échantillonnées, dans lesquelles $k$ désigne le rang de la fenêtre d'observation et $j$ désigne le rang de la valeur échantillonnée de tension respectivement de courant délivrés dans la fenêtre d'observation de rang $k$ considéré. En outre $K$ désigne la valeur finale du rang de la dernière fenêtre d'observation retenue et $N$ désigne la valeur finale du rang du dernier échantillon de tension respectivement de courants dans chaque fenêtre d'observation de rang $k$ considéré.

D'une manière générale, on indique que le regroupement des échantillons successifs de valeur de tension respectivement de courant délivrés peut être effectué par adressage sélectif en lecture-écriture des valeurs d'échantillons de tension et de courant délivrés en mémoire, de manière classique.

Les fenêtres successives d'observation ainsi obtenues peuvent avantageusement former des fenêtres sans recouvrement, l'application de gabarit de pondération et/ou d'observation des échantillons n'étant pas nécessaire.

Chaque fenêtre d'observation formée par une suite de $N$ échantillons de valeur de tension respectivement de courant délivrés correspond à une durée d'observation $\Delta t$ proportionnelle au nombre $N$ d'échantillons.

L'étape A de groupement précitée est alors suivie d'une étape B consistant à discriminer, sur chaque fenêtre temporelle d'observation courante, de rang $k$ successif, au moins l'ensemble des pôles notés $S_i$ et des résidus $R_i$ du signal de consommation par la méthode du Pencil.

À l'étape B de la figure 1a, l'opération de discrimination des pôles et des résidus est notée par la relation (3) :

Méthode du Pencil

$$\mathcal{P}\left[V_{kj}, P_{kj}\ I_{kj}\right]_{\substack{k=1 \\ j=1}}^{\substack{k=K \\ j=N}} \rightarrow \left[(S_i, R_i, SG_i)_{i=1}^{i=Nc}\right]_{k=1}^{k=K}$$

Dans la relation (3) précédente, $\mathcal{P}$ dénote l'application de la méthode du Pencil, par traitement de données appliqué aux échantillons ; $\lfloor V_{kj}, P_{kj}, I_{kj}\rfloor$ désigne chaque fenêtre d'observation de rang $k$ de $N$ échantillons ;

$$\left[\left(S_i, R_i, SG_i\right)_{i=1}^{i=Nc}\right]_{k=1}^{k=K}$$ désigne l'ensemble des pôles $S_i$, des résidus $R_i$ et des valeurs singulières $SG_i$ observés révélés par la méthode du Pencil sur la fenêtre d'observation de rang $k$ considéré.

Selon un aspect remarquable du procédé objet de l'invention, l'ensemble des pôles, des résidus et des valeurs singulières précités est représentatif, sur la fenêtre d'observation courante de rang $k$ considéré, d'une combinaison de signatures $\mathcal{S}_i$ de charges électriques $C_i$ distinctes.

On indique que selon un aspect spécifique non limitatif du procédé objet de l'invention, les pôles $S_i$, les résidus $R_i$ et les valeurs singulières $SG_i$ de toute charge électrique $C_i$ sont calculés sur l'une au moins des composantes de courant, de tension ou de puissance instantanée formant un signal de consommation délivrées à l'installation ainsi qu'il sera explicité ultérieurement dans la description.

Chaque signature $\mathcal{S}_i$ inclut au moins des pôles $S_i$ et des résidus $R_i$ déterminés associés à au moins une valeur singulière $SG_i$ représentative d'une charge et de la commutation de celle-ci en fonctionnement ou hors fonctionnement dans l'installation.

Ainsi, chaque signature $\mathcal{S}_i$ est formée par un triplet de valeurs numériques représentatives de pôles, de résidus et d'une valeur singulière, et représentée par la notation $\mathcal{S}_i$ $(S_i, R_i, SG_i)$.

L'étape B est alors suivie d'une étape C consistant à calculer la puissance électrique consommée sur au moins la durée de la fenêtre d'observation courante précitée. On comprend que, selon un mode de mise en oeuvre avantageux non limitatif du procédé objet de l'invention, le calcul de puissance précité peut être effectué au moins pour la puissance active consommée par au moins un sous-ensemble de charges électriques en fonctionnement dans l'installation, pour la puissance réactive ou finalement pour tout type de puissance électrique consommée.

Selon un aspect remarquable du procédé objet de l'invention, le calcul de la puissance consommée par au moins un sous-ensemble de charges électriques est établi comme la somme des puissances consommées par chaque charge électrique distincte de ce sous-ensemble, vérifiant une fonction de puissance consommée liant les pôles et résidus précités.

À l'étape C de la figure 1a, et à titre de seul exemple non limitatif pour la puissance active consommée, la fonction de puissance vérifie la relation (4):

$$P = \sum_{i=1}^{M}\sum_{i'=1}^{M'} R_{ci.}R_{vi'}.e^{\left(S_{ci}+S_{vi'}\right)\left(t_{kd}+\frac{\Delta t}{2}\right)} . \sinh c\left(\left(S_{ci}+S_{vi'}\right)\frac{\Delta t}{2}\right)$$

où $P$ : désigne la puissance active consommée par l'ensemble des charges électriques distinctes $C_i$ de signature $(S_i, R_i, SG_i)$ ;

$S_{ci}$ et $R_{ci}$ : désignent les pôles respectivement les résidus du courant échantillonné délivré à l'installation ;

$S_{vi'}$ et $R_{vi'}$ : désignent les pôles respectivement les résidus de la tension échantillonnée délivrée à l'installation ;

$t_{kd}$ : désigne l'instant de début de la fenêtre d'observation de rang $k$;

$\Delta t$ : désigne la durée de la fenêtre d'observation ; $\sinh c(X)$ : la fonction sinus hyperbolique du cardinal de la valeur X, soit

$$\sinh c\left(\left(S_{ci}+S_{vi'}\right)\frac{\Delta t}{2}\right) = \sinh\left(\left(S_{ci}+S_{vi'}\right)\frac{\Delta t}{2}\right)\Big/\left(\left(S_{ci}+S_{vi'}\right)\frac{\Delta t}{2}\right) \quad ;$$

$M$ : désigne le nombre de pôles et résidus observés du courant échantillonné délivré à l'installation ;

$M'$ : désigne le nombre de pôles et résidus observés de la tension échantillonné délivrée à l'installation.

La relation (4) exprime ainsi la fonction de puissance sur la fenêtre d'observation.

Différents justificatifs théoriques qualitatifs de processus permettant la mise en oeuvre du procédé objet de l'invention seront donnés ci-après.

D'une manière générale, on indique que le signal de consommation est formé par l'ensemble des valeurs échantillonnées de tension et ou de courant délivrés à l'installation, complété éventuellement par la valeur de puissance instantanée correspondant sensiblement au produit de la valeur échantillonnée de tension respectivement de courants délivrés à l'installation, ou à une combinaison de ces valeurs, ainsi qu'il sera explicité ultérieurement de manière plus détaillée dans la description.

La mise en oeuvre de la méthode du Pencil, par traitement des données appliquée aux valeurs précitées, opère le calcul d'une matrice de Hankel à partir d'une transformation par la méthode désignée méthode SVD pour <u>S</u>ingle <u>V</u>alue Décomposition en anglais.

Les pôles $S_i$ ainsi révélés représentent la contribution à la réponse de la charge au sens temporel au signal de consommation.

Les résidus $R_i$ représentent la contribution à la réponse de la charge au sens échange ou absorption d'énergie au signal de consommation.

Les valeurs singulières $SG_i$ représentent la transition d'un état de consommation à un autre du fait de l'enclenchement/déclenchement, total ou partiel, d'une charge de l'installation. Les valeurs singulières précitées sont directement liées à la mise en évidence des valeurs propres de la matrice de Hankel, lors de l'application de la méthode du Pencil.

A chaque fenêtre d'observation des valeurs échantillonnées, ou plus généralement du signal de consommation, correspond un ensemble de valeurs singulières.

Le changement de valeur singulière représente le changement ou transition du signal de consommation, car les valeurs singulières ont la même valeur en état stationnaire, en l'absence de commutation totale ou partielle de charge.

Les rebondissements des valeurs singulières sont liés à la valeur des pôles $S_i$.

L'apparition d'une valeur singulière sur la fenêtre d'observation ou sur une succession de fenêtre d'observation est sensiblement synchrone du changement de régime d'intensité du courant consommé par l'installation sur commutation simultanée ou non d'une ou plusieurs charges de l'installation.

Enfin la discrimination des pôles et des résidus permet de discriminer le type de charge en fonctionnement, charge résistive, capacitive ou inductive, ainsi qu'il sera décrit de manière plus détaillée dans la description ultérieurement.

D'une manière plus spécifique, on indique que, pour la mise en oeuvre du procédé objet de l'invention et pour une tension d'alimentation sensiblement périodique de pulsation $\omega$ et de période T, la durée $\Delta t$ de chaque fenêtre d'observation courante de rang $k$ peut-être prise égale à la période T.

Un tel choix de la durée de la fenêtre d'observation n'est pas indispensable. Toutefois, d'un point de vue granulaire de l'observation, le choix précité permet en quelque sorte une remise à l'état initial du réseau ou de l'installation et de la charge.

D'une manière plus générale, la durée de chaque fenêtre d'observation peut être choisie compte tenu de la fréquence d'échantillonnage *fe*, selon la relation (5) :

$$\Delta t.fe = Nem \geq 2.\left[\sum_{i=1}^{Nc} nci + 2(1+H)\right]$$

Dans la relation précédente,

*fe* désigne la fréquence d'échantillonnage ;

*Nem* désigne le nombre minimum d'échantillons sur la durée de chaque fenêtre d'observation ;

*Nc* désigne le nombre observé de charges électriques distinctes $C_i$ de l'installation d'abonné ;

*nci* désigne le nombre de pôles de la charge électrique $C_i$ considérée;

*H* désigne le nombre de composantes harmoniques de la fréquence fondamentale de la tension d'alimentation.

En référence à la figure 1b, on indique que le choix de la durée $\Delta t$ peut être effectué par exemple à partir de la relation précitée au cours d'une sous étape $A_1$ puis exécution du groupement correspondant en une sous étape successive $A_2$. Les étapes B et C peuvent alors être effectuées successivement.

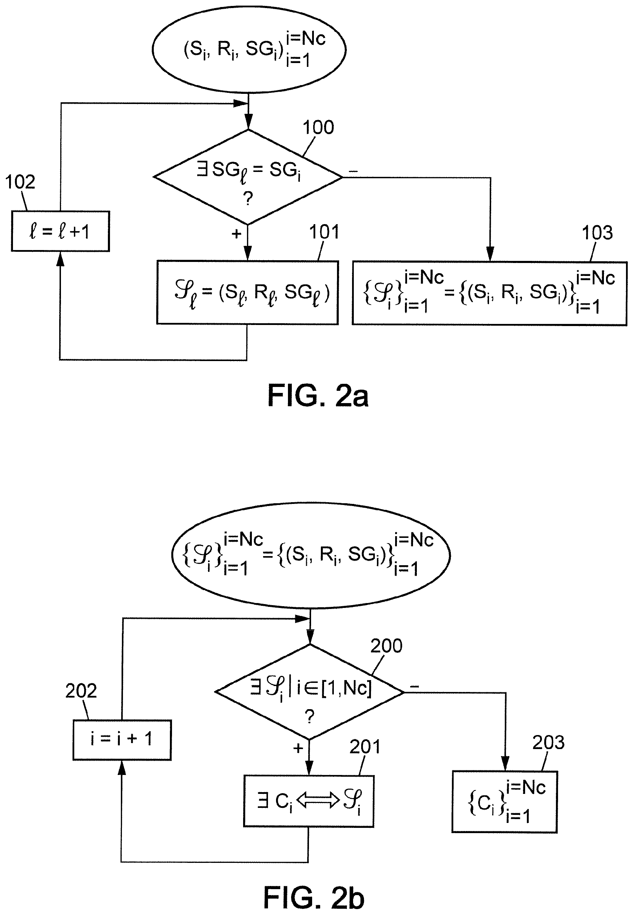

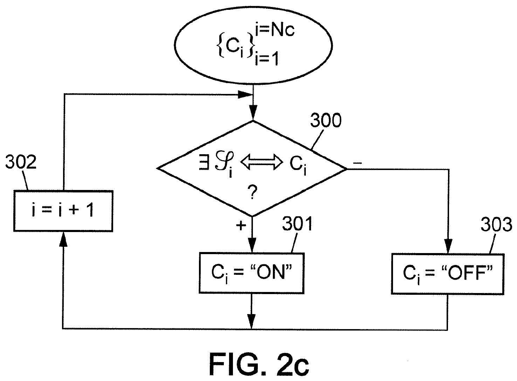

Une description plus détaillée d'étapes de discrimination et d'acquisition des signatures, d'identification des charges électriques constitutives du sous-ensemble de charges électriques distinctes puis de suivi de la mise en fonctionnement/hors fonctionnement de chaque charge distincte, conformément au procédé objet de l'invention, sera maintenant donnée en liaison avec les figures 2a, 2b et 2c respectivement.

D'une manière générale, on indique que les étapes précitées sont exécutées sur les valeurs numériques représentatives des résidus, des pôles et des valeurs singulières par des programmes de tri de ces valeurs numériques dont les organigrammes généraux sont représentés à titre purement illustratif sur les figures précitées.

En référence à la figure 2a, suite à étape consistant à discriminer l'ensemble des pôles et des résidus du signal de consommation, le procédé objet de l'invention comporte une étape de discrimination et d'acquisition des signatures

$\mathscr{S}_i$ $(S_i, R_i, SG_i)$ formées par un couple de pôles $S_i$, résidus $R_i$ auxquels est associé une valeur singulière $SG_i$.

Une description plus détaillée de processus permettant la mise en oeuvre d'une étape de discrimination et d'acquisition des signatures $\mathscr{S}_i$, d'identification des charges électriques $C_i$ en fonctionnement sur une fenêtre d'observation, respectivement de suivi de mise en fonctionnement/hors fonctionnement de chaque charge distincte sera maintenant donnée en liaison avec les figures 2a, 2b respectivement 2c.

En référence à la figure 2a, suite à l'étape consistant à discriminer l'ensemble des pôles $S_i$ et des résidus $R_i$ du signal de consommation, l'étape de discrimination et d'acquisition des signatures $\mathscr{S}_i$ peut être illustrée selon le processus représenté en figure précitée, à partir des triplets $\left(S_i, R_i, SG_i\right)\begin{subarray}{l} i=Nc \\ i=1 \end{subarray}$.

L'ensemble des triplets précités étant mémorisé sous forme d'une liste par exemple, on procède en une étape 100 à la lecture de chaque valeur singulière $SG_i$ dont on dispose dans l'ensemble des valeurs singulières $SG_i$ mémorisé selon la relation symbolique (6) :

$$\exists SG_i = SG_i \,?$$

Sur réponse positive au test 100, c'est-à-dire pour la lecture de la valeur singulière $SG_i$, on attribue aux triplets $(S_i,R_i,SG_i)$ un code d'identification de signature noté $\mathscr{S}_i$ correspondant, à l'étape 101.

Le processus est poursuivi pour la valeur singulière suivante d'indice $I$+1 par retour par l'étape 102 à l'étape 100 précitée, tant qu'il existe une valeur singulière non lue $SG_i$.

Au contraire, sur réponse négative au test de lecture de l'étape 100, le processus de lecture de l'ensemble des valeurs singulières est interrompu et l'on dispose à l'étape 103 de l'ensemble des signatures $\mathscr{S}_i$ de charges électriques $C_i$ susceptibles d'apparaître par une mise en fonctionnement/hors fonctionnement totale ou partielle sur l'installation considérée.

L'ensemble des signatures précitées peut alors être mémorisé dans une mémoire ou bibliothèque de signatures, ainsi qu'il sera décrit ultérieurement dans la description.

En référence à la figure 2b, l'étape d'acquisition des signatures précitées est alors suivie, avantageusement, d'une étape d'identification des charges électriques constitutives de tout sous-ensemble de charges électriques distinctes en fonctionnement sur au moins une fenêtre d'observation. On comprend, en particulier, que tout ou partie de l'ensemble des charges électriques de l'installation considérée peut-être mis en fonctionnement simultanément ou non, selon la mise en fonctionnement ou hors fonctionnement individuellement de chaque charge électrique de l'installation selon la seule volonté de l'utilisateur.

Ainsi, en référence à la figure 2b, on procède, à partir de l'ensemble des signatures mémorisées et bien entendu des triplets pôles, résidus valeur singulière associés à chacune de ces dernières à l'identification, en une étape 200, de l'existence sur l'installation des pôles, résidus et valeur singulière existants et observés en fonctionnement. Ce processus d'identification peut être réalisé par une comparaison des valeurs de pôles résidus et valeur singulière correspondant aux valeurs de triplets associés à la signature correspondante, avec un intervalle de confiance d'identification de ces valeurs.

Cette opération est représentée à l'étape 200 par la relation (7):

$$\exists \;\mathscr{S}_i \;\big| i \in \left[1, Nc\right]?$$

Sur réponse positive à l'étape 200 précitée, à la discrimination de la signature $\mathscr{S}_i$ est associée une charge électrique $C_i$ correspondante aux caractéristiques électriques spécifiques. On comprend, en particulier qu'une correspondance biunivoque peut être effectuée entre toute valeur de signature ou code de signatures $\mathscr{S}_i$ et les caractéristiques électriques de chaque charge électrique, grâce à la mise en oeuvre d'une bibliothèque de charges associée à la bibliothèque de signatures, ainsi qu'il sera décrit ultérieurement dans la description.

Les étapes 200, 201 sont poursuivies par passage à la signature suivante par retour à l'étape 200 par l'intermédiaire de l'étape 202 symbolisée par la relation $i=i$+1, pour toutes les signatures de charges électriques susceptibles d'être mises en fonctionnement sur l'installation.

Lorsque l'ensemble des signatures, et donc des charges électriques, susceptibles d'être mises en fonctionnement pour l'installation considérée a été soumis au test de l'étape 200, on dispose à l'étape 203 de l'ensemble des charges électriques en nombre $Nc$ en fonctionnement sur l'installation, noté selon la relation (8):

$$\left[ C_i \right]_{i=1}^{i=Nc}$$

Cet ensemble constitue un sous-ensemble de la totalité des charges électriques susceptibles d'être mis en fonctionnement pour l'installation considérée, sous-ensemble égal à tout ou partie de cette totalité.

On comprend bien entendu que la correspondance biunivoque entre la valeur ou code de signature $\mathscr{S}_i$, et la charge électrique $C_i$ correspondante est également établie avec le triplet $(S_i, R_i, SG_i)$ auquel ce dernier est associé.

La détection de la présence ou de l'absence de chaque triplet précité observé sur l'installation, et en conséquence de la signature $\mathscr{S}_i$ et de la charge électrique $C_i$ correspondante, permet, selon un aspect remarquable du procédé objet de l'invention, d'exécuter une étape de suivi de la mise en fonctionnement/hors fonctionnement de chaque charge individuelle distincte par discrimination de tout ou partie de la signature de cette dernière sur au moins une fenêtre d'observation.

On comprend en particulier que la discrimination précitée peut être exercée sur une ou plusieurs valeurs du triplet associé à cette charge, selon un processus de logique floue tel que décrit précédemment dans la description. Ainsi que représenté à titre d'exemple en figure 2c, pour toute charge électrique $C_i$ du sous-ensemble précité on procède en une étape de test 300 à l'identification de la signature $\mathscr{S}_i$, par discrimination des valeurs de pôles, résidus, valeur singulière ou d'une combinaison de ces derniers selon la relation (9):

$$\exists \ \mathscr{S}_i \ \Leftrightarrow C_i ?$$

Sur réponse positive au test 300, la charge électrique $C_i$ est déclarée en fonctionnement « ON » à l'étape 301. Au contraire sur réponse négative au test 301, la charge électrique $C_i$ est déclarée hors fonctionnement «OFF ».

Le processus de suivi peut être exécuté sur une durée quelconque par retour au test de l'étape 300 par l'intermédiaire de l'étape 302, notée $i=i+1$.

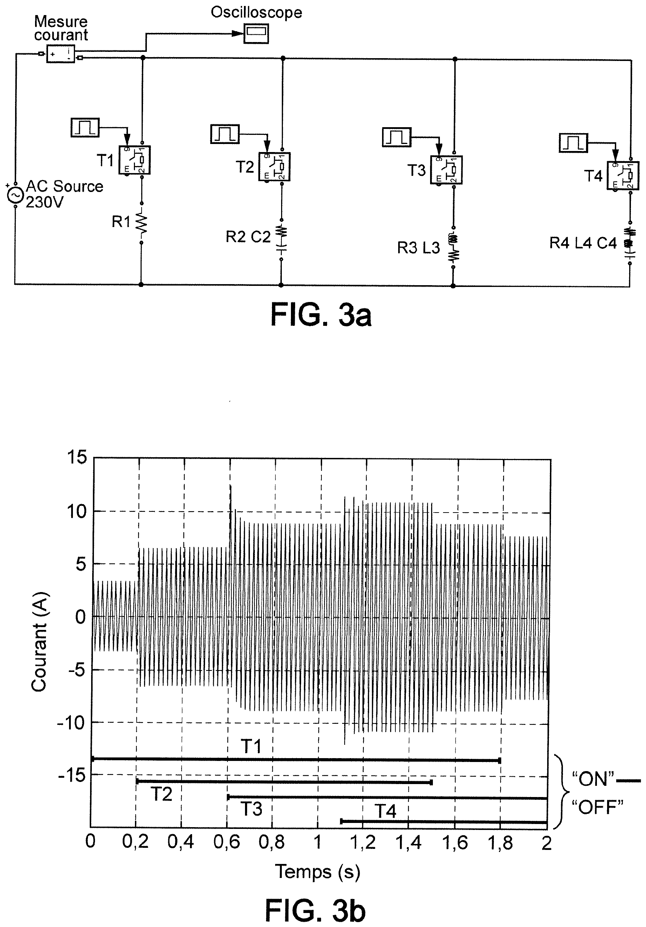

Un exemple de mise en oeuvre des processus précités, sur une installation représentée en figure 3a comportant une charge résistive pure $R_1$, une charge résistive-capacitive $R_2C_2$, une charge résistive-inductive $R_3L_3$ et une charge résistive capacitive et inductive $R_4L_4C_4$ est décrit ci-après.

On mesure le courant et la tension instantanés par échantillonnage à l'entrée de l'installation électrique d'une habitation. Ces deux signaux analogiques sont convertis en valeurs numériques à l'aide du CAN à la fréquence d'échantillonnage $fe = \dfrac{1}{Te}$ . A partir de ces deux mesures, on calcule la puissance instantanée consommée par les charges en présence, selon la relation précédemment mentionnée.

Les interrupteurs $T_1$, $T_2$, $T_3$ et $T_4$ commutent leur charge respective $R_1$, $R_2C_2$, $R_3L_3$ et $R_4C_4L_4$ selon la logique « ON », « OFF » indiquée sur la figure 3b,

On applique la méthode du Pencil sur chaque fenêtre d'observation de la puissance, de la tension et du courant d'alimentation.

Pour chaque fenêtre d'observation d'indice $k$, $N$ échantillons du signal sont prélevés.

La méthode du Pencil permet de filtrer le signal observé du bruit généré par la chaîne de mesure et de conversion, voire d'éliminer une composante non pertinente du signal. Elle fournit pour chaque fenêtre d'observation courante donnée de rang $k$, les vecteurs de taille $M$ des valeurs singulières $SG_{ik}$, des pôles $S_{ik}$, et des résidus $R_{ik}$ pour le courant, la tension et la puissance.

La mémorisation sélective des résultats successifs fournis par la méthode du Pencil permet d'exécuter le suivi temporel.

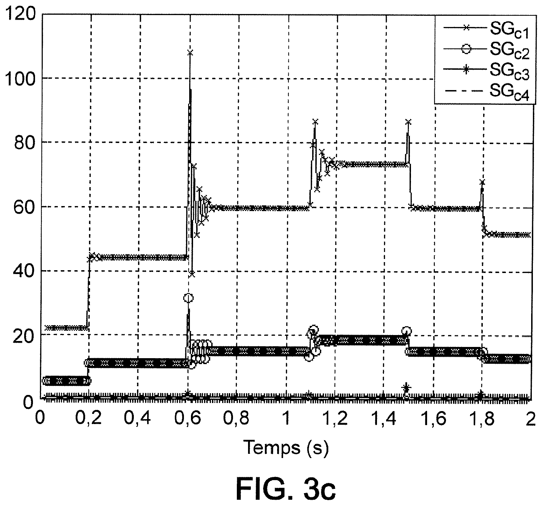

La méthode du Pencil est appliquée sur chaque fenêtre d'observation temporelle du courant. La durée $\Delta t$ de la fenêtre est paramétrable, elle est dans l'exemple donné choisie égale à $\Delta t=10ms$ dans le cas des figures 3c à 3g, soit une demie période pour une fréquence d'alimentation à 50 Hz.

Un exemple de suivi temporel des valeurs singulières est donné sur la figure 3c.

Sur la figure 3c, l'axe des abscisses est gradué en secondes et l'axe des ordonnées en valeur relative d'amplitude de valeur singulière, sans dimension. L'enveloppe du courant d'entrée représentée en figure 3b se retrouve au niveau de l'évolution des valeurs singulières ; leurs variations mettent en évidence les changements d'états, de manière sensiblement synchrone. Le nombre de pôles et de résidus pertinents est issu d'un traitement approprié de ces valeurs singulières.

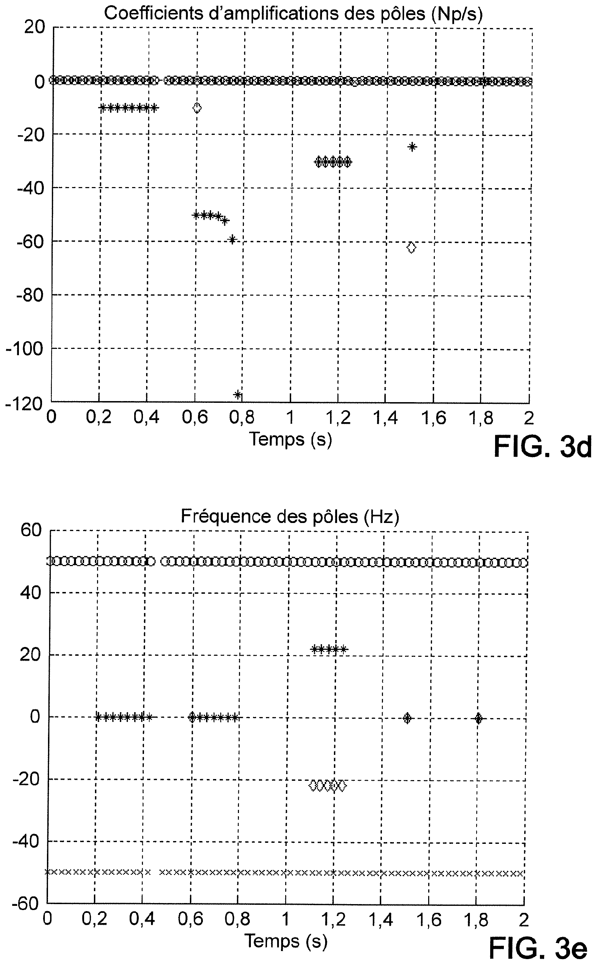

Le suivi temporel des parties réelles et imaginaires de chaque pôle est illustré respectivement sur les figures 3d et 3e.

Sur la figure 3d, l'axe des ordonnées est gradué en Népériens par seconde, Np/s, et, sur la figure 3e, l'axe des ordonnées est gradué en Hertz.

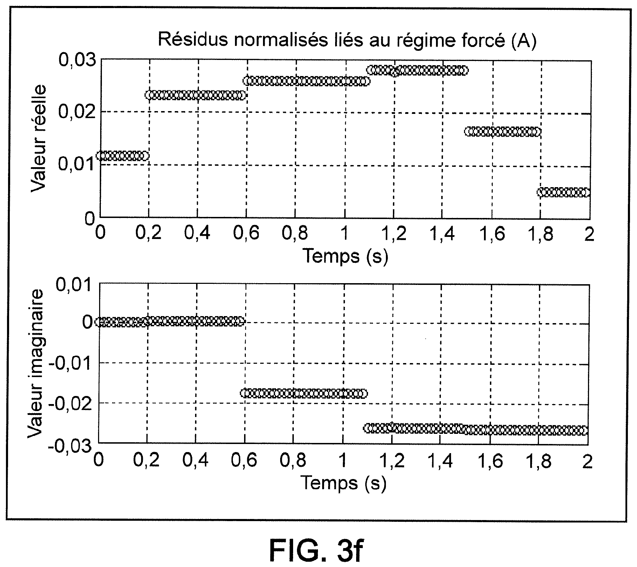

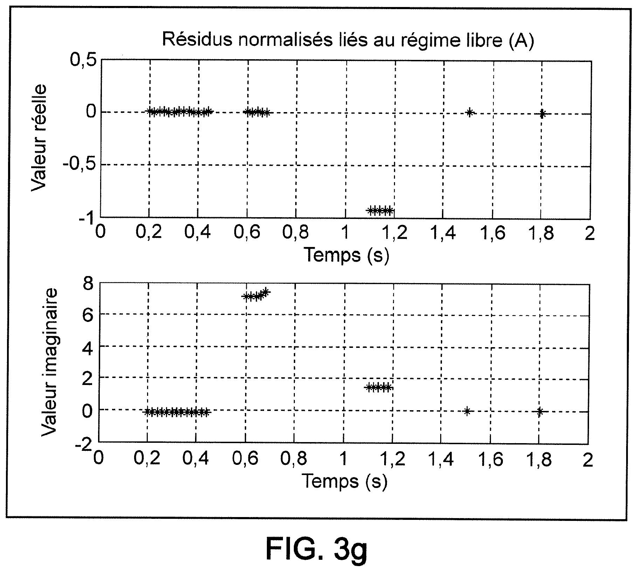

Selon un mode de réalisation préférentiel non limitatif, le suivi temporel des résidus est exprimé par celui de leurs valeurs normalisées, en régime forcé et en régime libre figures 3f et 3g. Ce choix, mieux approprié, facilite la classification par rapport aux résidus. Sur les figures 3f et 3g, l'axe des ordonnées est gradué en Ampères (A).

Ces suivis temporels délivrent des informations sur les caractéristiques des charges.

Les harmoniques, dont le fondamental, sont caractérisés par des pôles purement imaginaires, ils correspondent au régime forcé des charges.

Les régimes libres sont caractérisés par des pôles dont la partie réelle donne des informations sur les constantes de temps (confer figure 3d), et la partie imaginaire sur les fréquences propres (confer figure 3e). Les résidus sont directement liés aux charges en présence et aux harmoniques si ces fréquences existent.

Selon un mode de réalisation préféré, pour le régime forcé, on définit une valeur normalisée pour chaque résidu $R_{ik}$. Cette définition peut être donnée pour tout type de résidu, de tension, de courant, de puissance et, notamment pour les résidus de courant, donnée par l'expression suivante avec, pour l'exemple ci-après, $R_{ci}$ noté $\Re I_k^F$ désignant le résidu de courant et $S_{ci}$ noté $SI_k^F$ désignant le pôle de courant dans la fenêtre d'observation numéro k, $\Re IN_k^F$ désignant la valeur normalisée correspondante :

$$\Re IN_k^F = \Re I_k^F \cdot j \cdot \sqrt{2} \cdot e^{-SI_k^F \cdot t_{kd}}$$

avec :

$t_{kd}$, l'instant du début de la fenêtre d'observation numéro k ;

$\Re I_k^F$, le résidu du courant lié au régime forcé et relatif à la fenêtre k, pour la fréquence fondamentale et pour les fréquences harmoniques si elles existent ;

$SI_k^F$, le pôle du courant lié au régime forcé et correspondant au résidu du courant $\Re I_k^F$.

La figure 3f donne l'évolution temporelle des résidus normalisés de courant $\Re I_k^F$ liés aux fréquences positives.

Selon un mode de réalisation, l'exploitation des $\Re IN_k^F$ permet de remonter à la valeur de la charge.

Par analogie, on peut établir une normalisation des résidus du courant liés au régime libre de la manière suivante, $\Re IN_k^L$ désignant la valeur normalisée correspondante :

$$\Re IN_k^L = \Re I_k^L \cdot j \cdot \sqrt{2} \cdot e^{-SI_k^L \cdot (t_{kd} - t_0)}$$

avec

$t_{kd}$, instant du début de la fenêtre d'observation numéro k ;

$t_0$, instant d'enclenchement de la charge ;

$\Re I_k^L$, désigne le résidu du courant lié au régime libre et relatif à la fenêtre k ;

$SI_k^L$, désigne le pôle du courant lié au régime libre, relatif à la fenêtre k et correspondant au résidu $\Re I_k^L$.

La figure 3g donne l'évolution temporelle de $\Re IN_k^L$, résidu normalisé du courant lié au régime libre. Sur cette figure apparaissent trois instants d'enclenchement de charge, soit $t_0$ correspondant aux instants 0,2s, 0,61s et 1,1s.

Les pôles, figures 3d, 3e, liés à la fréquence positive de l'excitation sont représentés par des cercles « o ». Ceux liés à la fréquence négative conjuguée, sont représentés par des croix « x ». Les pôles liés au régime libre de la charge sont représentés par des étoiles et des losanges « * , ◊ ».

Les résidus normalisés, liés aux fréquences positives, sont représentés par des cercles « o » (figure 3f) dans le cas du régime forcé et par des étoiles « * » (figure 3g) pour le régime libre.

On comprend que le processus de suivi mis en oeuvre consiste essentiellement en une lecture des valeurs de pôles, résidus, valeurs singulières et en une comparaison de ces données pour détection d'un changement d'état.

Les instants de changement d'état sont détectés au niveau de la variation des valeurs singulières représentées en figure 3c. Ces instants apparaissent aussi au niveau du suivi des résidus normalisés. La figure 3f illustre ce phénomène.

L'interprétation des suivis temporels des pôles et des résidus normalisés donnés par les quatre figures 3d, 3e, 3f et 3g est la suivante :

Entre les instants 0s et 0.2s :

Entre ces deux instants, les figures 3d et 3e donnent deux pôles imaginaires purs $(0+50j)$ et $(0-50j)$ qui correspondent à la fréquence du $50Hz$. On comprend que la forme générale des pôles normalisés est donnée par $0\pm Fj$ où $F$ désigne la fréquence fondamentale de la tension d'alimentation et $j = \sqrt{-1}$ .

Si on considère qu'aucune charge n'est présente avant l'instant $t$=0, la variation du résidu lié au régime forcé, figure 3f, est de $\Delta\Re N1_{calc} = \left(2.3069 - 4.2406\cdot 10^{-6}\, j\right) - \left(0\right)$ .

Selon le mode de réalisation préféré, à partir de cette information on peut déduire le module de la charge ainsi que sa phase. A cet instant, on est en présence d'une charge de module 100Ω et de phase nulle.

Or, la valeur utilisée en expérimentation était une résistance de valeur $R_1$=100Ω et la valeur théorique du résidu normalisé est : $\Re N1_{Th} = 2.3 + 0\, j$

Entre les instants 0.2 et 0.6s :

Entre ces deux instants, les figures 3d et 3e montrent l'existence de trois pôles, $(0+50j)$, $(0-50j)$ et $(-10+0j)$. Ce dernier pôle indique le déclenchement à l'instant 0.2s d'une charge du premier ordre de constante de temps

$$\tau = \frac{1}{10} = 100ms \;.$$

Selon le mode de réalisation préféré, on calcule la variation des résidus normalisés liés au régime forcé à l'instant 0.2s, fournis par la figure 3f : $\Delta\Re N2_{calc} =$ (4.6022 + 7.3130·10$^{-2}$j)-(2.3069 - 4.2406·10$^{-6}$j)= 2.2953 + 7.3134·10$^{-2}$j Selon le mode de réalisation préféré et à partir de cette information, on peut alors calculer le module de la charge ainsi que sa phase. A cet instant on observe une charge de module 100.15Ω et de phase -0.0318$rd$(-1.822°). On en déduit le caractère capacitif de cette charge.

Or, la charge qui est enclenchée à l'instant précité est un circuit $RC$ série de résistance $R_2$=100Ω et de capacité $C_2$=1$mF$. La valeur théorique du résidu normalisé correspondant est $\Re N2_{Th} = 2.2977 + 7.313\cdot 10^{-2}\, j$ , elle est identique à celle issue de la méthode du Pencil.

Entre les instants 0.6s et 1.1s :

Entre ces deux instants, les figures 3d et 3e donnent trois pôles, $(0+50j)$ et $(0-50j)$ ainsi qu'un nouveau pôle $(-50+0j)$. Ce dernier pôle indique l'enclenchement à l'instant 0.6s d'une charge du premier ordre de constante de temps

$$\tau = \frac{1}{50} = 20\;ms \;.$$

Selon le mode de réalisation préféré, on calcule la variation des résidus normalisés liés au régime forcé à l'instant 0.6s, fournis par la figure 3e :

$$\Delta \Re N3_{calc} = \left(5.168 \; - \; 3.4970\,j\right) - \left(4.6022 \; + \; 7.3130 \cdot 10^{-2}\,j\right) = 0.56590 \; - \; 3.5701\,j$$

Selon le mode de réalisation préféré et à partir de cette information, on peut déduire le module de la charge ainsi que sa phase. A cet instant on est en présence d'une charge de module 63.62Ω et de phase 1.413$rd$(80.9589°). On en déduit le caractère inductif de cette charge.

Or, la charge enclenchée est un circuit $RL$ série de résistance $R_3$=10Ω et d'inductance $L_3$=0.2$H$. La valeur théorique du résidu normalisé correspondant est $\Re N3_{th} = 0.56820 \; - \; 3.5701\,j$, elle est identique à celle issue de la méthode du Pencil.

Entre les instants 1.1s et 1.5s :

Entre ces deux instants, les figures 3d et 3e donnent quatre pôles, (0+50$j$) et (0-50$j$) relatifs à la fréquence fondamentale ainsi que (-30+22$j$) et (-30-22$j$) relatifs à la fréquence propre de la charge. A partir de ces pôles, on peut reconnaître la présence d'une charge du second ordre à l'instant 1.1s (apparition de deux pôles complexes conjugués).

A cet instant, selon le mode de réalisation préféré, on calcule la variation des résidus normalisés liés au régime forcé :

$$\Delta \Re N4_{calc} = \left(5.5818 \; - \; 5.2337\,j\right) - \left(5.168 \; - \; 3.4970\,j\right) = \; 0.41370 \; - \; 1.7367\,j$$

Selon le mode de réalisation préféré et à partir de cette information, on peut calculer le module de la charge ainsi que sa phase. A cet instant on a une charge de module 128.83Ω et de phase 1.3369$rd$(76.5987°). On en déduit le caractère inductif de cette charge.

Or, la charge enclenchée est un circuit $RLC$ série de résistance $R_4$=30Ω, d'inductance $L_4$=0.5$H$ et de capacité $C_4$=0.1$mF$. Le résidu normalisé théorique correspondant est $\Re N4_{th} = 0.41598 \; - \; 1.7367\,j$, il est identique à celui issu de la méthode du Pencil.

Entre les instants 1.5s et 1.8s :

La variation négative des valeurs singulières à l'instant 1.5s indique la mise hors tension d'une des quatre charges mises sous tension entre les instants 0s et 1.5s d'une part. D'autre part, la variation des résidus normalisés du régime forcé est de $\Delta \Re N5_{calc} = -2.2953 \; - \; 7.31 \cdot 10^{-2}\,j$. Selon le mode de réalisation préféré, on en déduit la mise hors tension de la charge n° 2, qui s'était enclenchée à l'instant 0.2s.

Entre les instants 1.8s et 2s :

La variation négative des valeurs singulières à l'instant 1.8s indique la mise hors tension d'une des quatre charges mises sous tension entre les instants 0s et 1.8s d'une part. D'autre part, la variation des résidus normalisés du régime forcé est de $\Delta \Re N6_{calc} = -2.2977 \; + \; 0\,j$. Selon le mode de réalisation préféré, on en déduit la mise hors tension de la charge n° 1 qui s'est enclenchée à l'instant 0s.

Ainsi, selon un aspect remarquable du procédé objet de l'invention, on comprend que la discrimination de l'ensemble des pôles $S_i$, des résidus $R_i$ et des valeurs singulières $SG_i$ est effectuée par lecture des valeurs correspondantes révélées par l'application de la méthode du Pencil.

En outre, dans le mode de mise en oeuvre préféré du procédé objet de l'invention, dans lequel les pôles et les résidus sont établis selon leur définition normalisée, le suivi de mise en fonctionnement/hors fonctionnement de chaque charge électrique individuelle $C_i$ peut, de manière particulièrement avantageuse, être mis en oeuvre par simple calcul de la variation algébrique des résidus normalisés. En particulier l'apparition, enclenchement, d'une charge est révélée par l'apparition de la valeur algébrique du résidu $R_i$ associé à cette charge et la disparition, déclenchement, de cette charge est révélée par l'apparition de la valeur algébrique opposée du résidu $R_i$ associé à cette charge.

Un récapitulatif des caractéristiques des résidus, pôles et valeurs singulières, en définitive des signatures obtenues en fonction de caractéristiques électriques de charges électriques enclenchées respectivement déclenchées sur une installation sera maintenant donné ci-après.

On considère une fenêtre d'observation, ou une succession de fenêtres d'observation, du signal de consommation incluant le régime libre et le commencement du régime forcé d'enclenchement/déclenchement d'une charge électrique.

De manière caractéristique :

- l'enclenchement/déclenchement d'une charge purement résistive est signé par un régime forcé unique, par l'existence, pour la fenêtre d'observation considérée, de deux pôles complexes conjugués à partie réelle nulle et de deux résidus complexes conjugués dans le régime forcé.

En outre, les résidus présentent une phase nulle en régime forcé.

Le tableau désigné **Tableau charge résistive** donne les valeurs des pôles et résidus normalisés correspondants.

**Tableau charge résistive** :

|  | Régime forcé | |
|---|---|---|
| Pôles | (0+50.*j*) | (0-50.*j*) |
| Résidus | (*x+y.j*) | (*x-y.j*) |

L'existence de deux valeurs pour les pôles et les résidus, ainsi que la phase nulle des résidus normalisés liés au régime forcé permettent de déduire la nature résistive de la charge en cours d'analyse ;

- l'enclenchement/déclenchement d'une charge résistive et capacitive est signé par un régime libre et un régime forcé distincts, l'existence pour la fenêtre d'observation de deux pôles complexes conjugués à partie réelle nulle et de deux résidus complexes conjugués dans le régime forcé et par un pôle réel et un résidu complexe dans le régime libre. La phase négative du résidu en régime forcé caractérise la nature globalement capacitive de la charge.

**Tableau charge RC** :

|  | Régime forcé | | Régime libre |
|---|---|---|---|
| Pôles | (0+50.*j*) | (0-50.*j*) | ($\alpha$+0.*j*) |
| Résidus | (*x+y.j*) | (*x-y.j*) | (*a+b.j*) |

La phase des résidus normalisés liés au régime permanent est négative. La comparaison de la valeur absolue de la phase avec le produit $\alpha.\omega$ ou l'inverse de ce produit permet de déduire l'existence d'une charge RC en série ou d'une charge RC en parallèle.

- l'enclenchement/déclenchement d'une charge résistive et inductive est signé par un régime libre et un régime forcé distincts, par l'existence pour la fenêtre d'observation de deux pôles complexes conjugués à partie réelle nulle et de deux résidus complexes conjugués dans le régime forcé et par un pôle réel et un résidu complexe dans le régime libre. La phase positive du résidu caractérise la nature globalement inductive de la charge.

**Tableau charge RL** :

|  | Régime forcé | | Régime libre |
|---|---|---|---|
| Pôles | (0+50.*j*) | (0-50.*j*) | ($\alpha$+0.*j*) |
| Résidus | (*x+y.j*) | (*x-y.j*) | (*a+b.j*) |

La phase des résidus normalisés liés au régime libre est positive.

La comparaison de la valeur absolue de la phase avec le produit $\alpha.\omega$ ou l'inverse de ce dernier permet de déduire l'existence d'une charge RL en série ou d'une charge RL en parallèle.

- l'enclenchement/déclenchement d'une charge résistive, inductive et capacitive est signé par un régime forcé et un régime libre distincts et par l'existence, en régime forcé, de deux pôles complexes conjugués à partie réelle nulle et de deux résidus complexes conjugués et, en régime libre, de deux pôles complexes conjugués et deux résidus complexes conjugués. La phase négative du résidu en régime forcé caractérise la nature globalement capacitive de la charge et la phase positive du résidu en régime forcé caractérise la nature globalement inductive de la charge.

**Tableau charge RLC** :

|  | Régime forcé | | Régime libre | |
|---|---|---|---|---|
| Pôles | $(0+50.j)$ | $(0-50.j)$ | $(\alpha+\beta.j)$ | $(\alpha-\beta.j)$ |
| Résidus | $(x+y.j)$ | $(x-y.j)$ | $(a+b.j)$ | $(a-b.j)$ |

On rappelle que l'ensemble des valeurs de pôles et de résidus donné aux tableaux précédents est obtenu par l'application de la méthode du Pencil. En particulier, dans l'exemple des valeurs données, les valeurs numériques 50 affectées à la partie imaginaire des pôles correspond en fait à la valeur de la fréquence fondamentale de la tension d'alimentation de l'installation. Cette valeur est remplacée par la valeur 60 pour la mise en oeuvre du procédé objet de l'invention dans les pays dans lesquels les réseaux d'alimentation en énergie électrique sont des réseaux alternatifs à la fréquence 60 Hz.

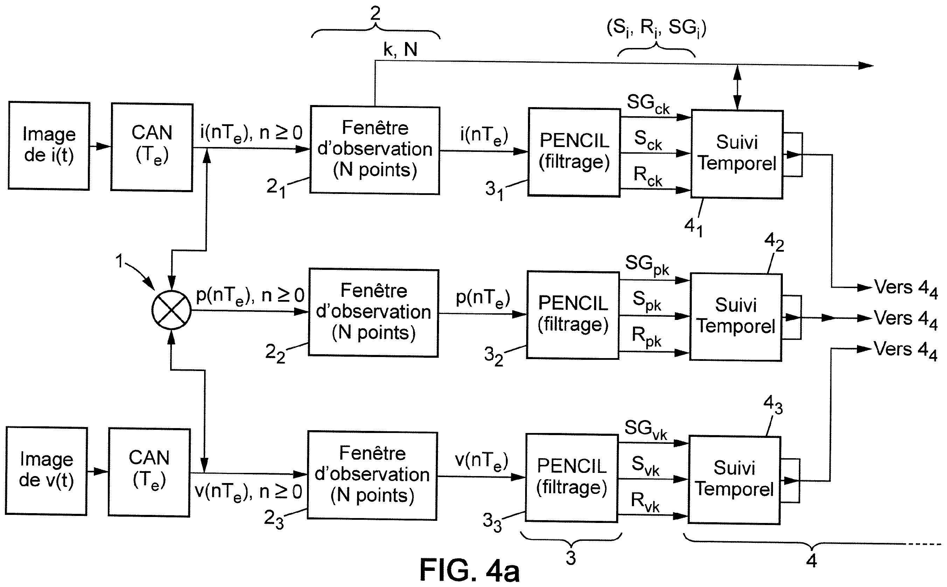

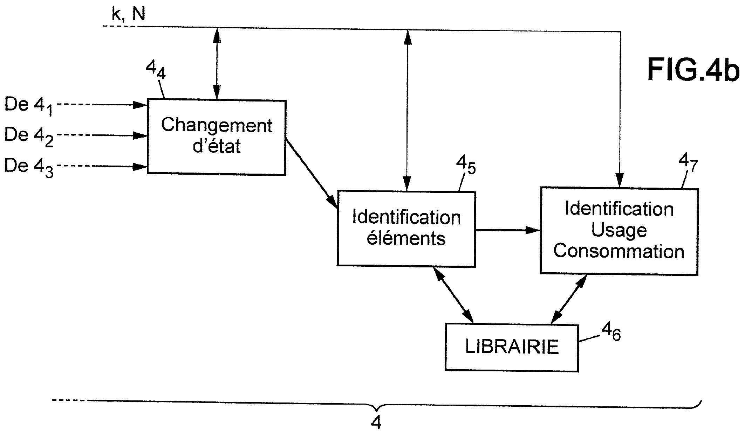

Une description plus détaillée d'un dispositif de détermination non intrusif de la puissance électrique consommée par une installation d'abonné, conforme à l'objet de la présente invention, sera maintenant donnée en liaison avec la figure 4a et la figure 4b.

Ainsi qu'on l'a représenté sur la figure 4a précitée, le dispositif objet de l'invention comprend des ressources d'échantillonnage périodique des valeurs de tension d'alimentation et de l'intensité du courant électrique délivrés à l'installation considérée, en vue d'obtenir un signal de consommation.

Sur la figure précitée, les ressources correspondantes sont réputées constituées par un circuit délivrant une image de la tension d'alimentation et un circuit délivrant une image de l'intensité du courant électrique délivrés à l'installation. Ces circuits peuvent avantageusement être constitués par tout circuit de prélèvement de tension respectivement de courant accompagnés d'échantillonneurs appropriés délivrant dans les conditions d'échantillonnage de Shannon une image de la tension respectivement de l'intensité du courant délivré. Ces circuits peuvent être suivis de convertisseurs analogiques et numériques à la fréquence ou période d'échantillonnage désignée $T_e$. Ce type de circuit ne sera pas décrit en détail car il correspond à des circuits connus de l'homme de l'art dans le domaine technique correspondant.

Chaque circuit convertisseur analogique numérique CAN délivre avec un rythme correspondant à la période d'échantillonnage $T_e$ les échantillons de tension notés $v(nT_e)$ respectivement de courant $i(nT_e)$, pour bien entendu $n \geq 0$, $n$ désignant le rang de l'échantillon.

Selon une caractéristique particulièrement avantageuse, le dispositif objet de l'invention comporte une ressource de calcul 1 de la puissance instantanée délivrée, produit des valeurs échantillonnées des valeurs de tension d'alimentation et de l'intensité du courant électrique délivré. Ainsi, sur la figure 4a, la ressource de calcul 1 reçoit les valeurs échantillonnées de courants $i(nT_e)$, et de tension $v(nT_e)$ et délivre une valeur produit de ces valeurs reçues, constitutive de la valeur de puissance instantanée délivrée notée $p(nT_e)$.

Selon une autre caractéristique du procédé et du dispositif objets de l'invention, le signal de consommation est constitué par un au moins des échantillons d'intensité délivrée $i(nT_e)$, de tension délivrée $v(nT_e)$ et de puissance instantanée délivrée $p(nT_e)$ à l'installation. Les composantes du signal de consommation précitées sont soumises à observation pour détermination des pôles, des résidus et des valeurs singulières grâce au dispositif objet de l'invention de la manière ci-après.

Le dispositif selon l'invention, représenté en figure 4a comporte dans ce but des ressources de mémorisation et de lecture des valeurs successives du signal de consommation sur au moins une fenêtre d'observation, les opérations de mémorisation et de lecture étant bien entendu exécutées sur plusieurs fenêtres d'observation successive.

Il comporte par exemple, ainsi que représenté en figure 4a, des ressources de création de fenêtres d'observation sur les composantes d'intensité, de tension et de puissance précitées. Ces ressources sont notées $2_1$, $2_2$, $2_3$ sur cette figure. Elles peuvent consister de manière classique en des circuits d'adressage en écriture/lecture en mémoire des composantes précitées mémorisées pour une pluralité de valeurs successives de rang n compris entre $(k-1)N$ et $kN-1$, $N$ désignant le nombre d'échantillons dans la fenêtre de rang $k$ considérée, en liaison avec le figure la.

Le dispositif objet de l'invention représenté en figure 4a comporte en outre des ressources 3 d'application, sur le signal de consommation et sur au moins une fenêtre d'observation courante, tel que défini précédemment, d'un traitement de filtrage par la méthode du Pencil, ceci dans le but de discriminer sur la fenêtre du signal de consommation l'ensemble des pôles et résidus représentatifs, avec les valeurs singulières, d'une combinaison de signatures de charges électriques distinctes en fonctionnement dans l'installation considérée.

À l'observation de la figure 4a, on constatera que les ressources 3 d'application du traitement de filtrage par la méthode du Pencil comportent avantageusement des modules séparés portant la référence $3_1, 3_2, 3_3$, chacun recevant les composantes d'intensité, de puissance respectivement de tension du signal de consommation précitée.

Chaque module séparé $3_1, 3_2, 3_3$ peut être constitué par un calculateur dédié incorporant un programme de traitement approprié.

Chacun des modules précités délivre les pôles, les résidus et les valeurs singulières pour la composante d'intensité, de puissance instantanée, de tension du signal de consommation, ces valeurs étant respectivement désignées $S_{Ck}, R_{Ck}, SG_{Ck}$ pour la composante d'intensité, $S_{pk}, R_{pk}, SG_{pk}$ pour la composante de puissance instantanée, $S_{Vk}, R_{Vk}, SG_{Vk}$ pour la composante de tension délivrée à l'installation. Les valeurs précitées ne sont autres, bien entendu, que les valeurs de pôles $S_i$, de résidus $R_i$ et de valeurs singulières $SG_i$ précédemment mentionnées dans la description.

En outre, ainsi que représenté en figure 4a et 4b, le dispositif selon l'invention comprend des ressources 4 de suivi temporel de la combinaison de signatures et donc des charges électriques et de calcul sur au moins la durée de la fenêtre d'observation courante de rang k d'au moins la puissance active consommée par au moins un sous-ensemble de charges électriques en fonctionnement dans l'installation. La puissance calculée précitée est exprimée comme la somme des puissances, telles que la puissance active, consommée par chaque charge électrique distincte du sous-ensemble précité vérifiant une fonction de puissance consommée liant les pôles et les résidus.

On comprend bien sûr que la fonction de puissance liant les pôles et les résidus, notamment pour la puissance active, vérifie la relation (4) précédemment mentionnés dans la description.

On observera également sur la figure 4a que les ressources 4 de suivi temporel de la combinaison de signatures comportent également des modules séparés référencés $4_1, 4_2, 4_3$ opérant sur les pôles, résidus, valeurs singulières de la composante d'intensité, de puissance respectivement de tension délivrée à l'installation.

En particulier, le suivi temporel de la combinaison des signatures est exécuté conformément au processus décrit en liaison avec les figures 2a à 2c, en particulier par détection de la variation algébrique des valeurs des résidus et des pôles correspondants par exemple.

En outre, les ressources 4 de suivi temporel sont maintenant décrites ci-après en détail en référence à la figure 4b.

En référence à la figure 4b précitée, les ressources 4 de suivi temporel comportent, en outre, au moins un module $4_4$ de détection de changement d'état d'enclenchement/déclenchement de charge électrique, lequel reçoit les valeurs numériques représentatives de la combinaison de signatures délivrées par chaque module séparé $4_1, 4_2$ et $4_3$ est directement relié à un module $4_5$ d'identification des charges électriques enclenchées et/ou déclenchées à partir des signatures de charges électriques précitées.

Le module $4_5$ d'identification des charges électriques enclenchées et/ou déclenchées est lui-même relié à un module $4_6$ de librairie de charges électriques identifiées en relation avec leurs signatures et à un module $4_7$ d'identification des usages de consommation de l'utilisation abonné et de calcul de la consommation au moins en puissance active.

Ainsi que représenté sur les figures 4a et 4b précitées, les modules $4_{1 à} 4_7$ sont bien entendu synchronisés par un signal noté $k, N$ sur la lecture de chaque fenêtre d'observation de rang $k$ comportant, pour un nombre $N$ d'échantillons, un nombre donné de valeurs de résidus, pôles, valeurs singulières délivrées par chaque module respectif $3_1, 3_2, 3_3$ relatif aux composantes d'intensité, de puissance instantanée respectivement de tension, ainsi que décrit précédemment dans la description.

Chacun des modules précités opère pour l'exécution du suivi par lecture des valeurs de pôles, de résidus et de valeur singulière correspondante, ainsi que décrit précédemment dans la description, en liaison avec les figures 2c et 3b à 3g.

On comprend, en particulier, que les modules de filtrage $3_1, 3_2$ et $3_3$ peuvent être constitués par un programme d'ordinateur exécutable par un ordinateur ou par l'unité centrale de traitement d'un dispositif dédié permettant en fait l'application de la méthode du Pencil aux échantillons des composantes d'intensité du courant, de la puissance instantanée et de la tension d'alimentation délivrées à l'installation pour l'obtention des valeurs singulières, pôles et résidus relatifs aux composantes du signal de consommation précitées.

On comprend également que les modules de suivi temporel $4_1, 4_2, 4_3$ peuvent également être constitués par un programme d'ordinateur exécutable par un ordinateur ou par l'unité centrale de traitement d'un dispositif dédié permettant en fait l'application du processus de suivi temporel de l'enclenchement/déclenchement de charges électriques tel que représenté aux figures 2c, 3b à 3g, ainsi que décrit précédemment dans la description.

En ce qui concerne le module $4_6$ de librairie, on indique que ce dernier permet la mise en correspondance biunivoque entre la valeur de signature ou de code de signature $\mathscr{S}_i$, la valeur des pôles, résidus et valeur singulière correspondante et en outre de toutes caractéristiques électriques et ou électromécaniques caractéristique de charges électriques normalement disponibles dans le commerce et permettant de déduire un suivi de consommation par charge électrique spécifique. Ce programme d'ordinateur comporte au moins une routine de calcul de la puissance active consommée par chaque charge électrique distincte vérifiant une fonction de puissance consommée liant les pôles et les résidus du signal de consommation, vérifiant la relation (4) précédemment décrite.

Dans un exemple de mise en oeuvre non limitatif, la valeur du code allouée à la signature $\mathcal{S}_i$ d'une charge électrique $C_i$ est une valeur unique obtenue par paramétrage d'un processus de signature, tel que le processus ou algorithme RSA (<u>R</u>ivest <u>S</u>hamir <u>A</u>deleman) par exemple, à partir des valeurs de résidus, pôles et valeur singulière correspondante.

Le procédé et le dispositif objets de l'invention sont particulièrement adaptés à la mise en oeuvre de processus de détection et de suivi des usages de consommation électrique de clients. Le module $4_7$ d'identification des usages de consommation peut mettre en oeuvre des techniques de détection et de suivi des usages de consommation basées sur des techniques statistiques connues de l'homme de l'art.

**Revendications**

1. Procédé de détermination non intrusive de la puissance électrique consommée par une installation d'abonné, dans lequel on procède à un échantillonnage périodique des valeurs de tension d'alimentation et de l'intensité du courant électrique délivrés à cette installation pour obtenir un signal de consommation, **caractérisé en ce que** celui-ci consiste au moins, à partir des valeurs échantillonnées du signal de consommation, à :

   - grouper lesdites valeurs échantillonnées sur des fenêtres temporelles d'observation successives ;
   - discriminer sur chaque fenêtre temporelle d'observation courante successives l'ensemble des pôles ($S_i$) et des résidus ($R_i$) du signal de consommation par la méthode du Pencil, ledit ensemble des pôles et résidus étant représentatif, sur la fenêtre d'observation courante, d'une combinaison de signatures de charges électriques ($C_i$) distinctes incluant au moins des pôles ($S_i$) et des résidus ($R_i$) déterminés associées à au moins une valeur singulière ($SG_i$) obtenue par la méthode du Pencil en fonctionnement dans ladite installation ;
   - calculer, sur au moins la durée de ladite fenêtre d'observation courante, au moins la puissance active consommée par au moins un sous-ensemble des charges électriques en fonctionnement dans l'installation, exprimée comme la somme des puissances actives consommées par chaque charge électrique distincte de ce sous-ensemble vérifiant une fonction de puissance consommée liant lesdits pôles et résidus.

2. Procédé selon la revendication 1, **caractérisé en ce que**, pour ladite puissance active, ladite fonction vérifie la relation :

$$P = \sum_{i=1}^{M} \sum_{i'=1}^{M'} R_{ci.} R_{vi'}.e^{(S_{ci}+S_{vi'})\left(t_{kd} + \frac{\Delta t}{2}\right)} . \sinh c\left((S_{ci} + S_{vi'})\frac{\Delta t}{2}\right)$$

où $P$ : désigne la puissance active consommée par l'ensemble des charges électriques distinctes $C_i$ de signature ($S_i,R_i,SG_i$) ;
$S_{ci}$ et $R_{ci}$ : désignent les pôles respectivement les résidus du courant échantillonné délivré à l'installation ;
$S_{vi'}$ et $R_{vi'}$ : désignent les pôles respectivement les résidus de la tension échantillonnée délivrée à l'installation, $SG_i$ désignant les valeurs singulières ;
$t_{kd}$ : désigne l'instant de début de la fenêtre d'observation de rang $k$;
$\Delta t$ : désigne la durée de la fenêtre d'observation ;
$\sinh c(X)$ : la fonction sinus hyperbolique du cardinal de la valeur X, soit

$$\sinh c\left((S_{ci} + S_{vi'})\frac{\Delta t}{2}\right) = \sinh\left((S_{ci} + S_{vi'})\frac{\Delta t}{2}\right) \bigg/ \left((S_{ci} + S_{vi'})\frac{\Delta t}{2}\right) \; ;$$

$M$ : désigne le nombre de pôles et résidus du courant échantillonné délivré à l'installation ;
$M'$ : désigne le nombre de pôles et résidus de la tension échantillonné délivrée à l'installation.

3. Procédé selon la revendication 1 ou 2, **caractérisé en ce que** pour une tension d'alimentation sensiblement périodique de pulsation $\omega$ et de période T, la durée $\Delta t$ de chaque fenêtre d'observation courante est prise égale à ladite période.

4. Procédé selon l'une des revendications 1 à 3, **caractérisé en ce que** la fréquence d'échantillonnage pour obtenir ledit signal de consommation et ladite durée $\Delta t$ de chaque fenêtre d'observation sont liées par la relation :

$$\Delta t \cdot fe = Nem \geq 2 \left[ \sum_{i=1}^{Nc} nci + 2\left(1 + H\right) \right]$$

dans laquelle :

$fe$ : désigne la fréquence d'échantillonnage ;
$Nem$ : désigne le nombre minimum d'échantillons sur la durée de chaque fenêtre d'observation ;
$Nc$ : désigne le nombre observé de charges électriques distinctes ($C_i$) de l'installation d'abonné ;
$nci$ : désigne le nombre de pôles de la charge électrique ($C_i$) ;
$H$ : désigne le nombre de composantes harmoniques de la fréquence fondamentale de la tension d'alimentation.

5. Procédé selon l'une des revendications 1 à 4, **caractérisé en ce que**, suite à l'étape consistant à discriminer l'ensemble des pôles ($S_i$) et des résidus ($R_i$) du signal de consommation, celui-ci comporte en outre une étape de discrimination et d'acquisition des signatures formées par un couple de pôles ($S_i$), résidus ($R_i$) de chaque charge électrique distincte ($C_i$) et des valeurs singulières ($SG_i$).

6. Procédé selon la revendication 5, **caractérisé en ce que**, suite à l'acquisition desdites signatures ($S_i, R_i, SG_i$) ledit procédé comprend une étape d'identification desdites charges électriques constitutives dudit sous-ensemble de charges électriques distinctes en fonctionnement sur au moins une fenêtre d'observation.

7. Procédé selon la revendication 5 ou 6, **caractérisé en ce que**, suite à l'acquisition desdites signatures *(Si,Ri,SGi),* ledit procédé comprend une étape de suivi du fonctionnement/mise hors fonctionnement de chaque charge distincte, par discrimination de tout ou partie de la signature sur au moins une fenêtre d'observation.

8. Procédé selon l'une des revendications 6 ou 7, **caractérisé en ce que**, pour une fenêtre d'observation du signal de consommation incluant le régime libre et le commencement du régime forcé d'enclenchement/déclenchement d'une charge,

- l'enclenchement/déclenchement d'une charge purement résistive est signé par un régime forcé unique, par l'existence, pour la fenêtre d'observation, de deux pôles complexes conjugués à partie réelle nulle et de deux résidus complexes conjugués dans le régime forcé, et par la phase nulle des résidus en régime forcé ;
- l'enclenchement/déclenchement d'une charge résistive et capacitive est signé par un régime libre et un régime forcé distincts, l'existence, pour la fenêtre d'observation, de deux pôles complexes conjugués à partie réelle nulle et de deux résidus complexes conjugués dans le régime forcé et par un pôle réel et un résidu dans le régime libre, la phase négative du résidu en régime forcé caractérisant la nature globalement capacitive de la charge ;
- l'enclenchement/déclenchement d'une charge résistive et inductive est signé par un régime libre et un régime forcé distincts, par l'existence, pour la fenêtre d'observation, deux pôles, complexes conjugués à partie réelle nulle et de deux résidus complexes conjugués dans le régime forcé et par un pôle réel et un résidu complexe, dans le régime libre, la phase positive du résidu caractérisant la nature globalement inductive de la charge.

9. Procédé selon l'une des revendications 6 ou 7, **caractérisé en ce que**, pour une fenêtre d'observation du signal de consommation incluant le régime libre et le début du régime forcé d'enclenchement/déclenchement d'une charge, l'enclenchement/déclenchement d'une charge résistive, inductive et capacitive est signé par un régime forcé et un régime libre distincts, par l'existence :

- en régime forcé, de deux pôles complexes conjugués à partie réelle nulle et de deux résidus complexes conjugués ; et,
- en régime libre, de deux pôles complexes conjugués et deux résidus complexes conjugués, la phase négative du résidu en régime forcé caractérisant la nature globalement capacitive de la charge et la phase positive du résidu en régime forcé caractérisant la nature globalement inductive de la charge.

10. Dispositif de détermination non intrusive de la puissance électrique consommée par une installation d'abonné, comportant au moins des moyens d'échantillonnage périodique des valeurs de tension d'alimentation et de l'intensité du courant électrique délivrés à cette installation pour obtenir un signal de consommation, **caractérisé en ce que** ledit dispositif comporte en outre au moins :

- des moyens de calcul de la puissance instantanée délivrée produit des valeurs échantillonnées des valeurs de tension d'alimentation et de l'intensité du courant électrique délivrés, ledit signal de consommation comportant l'une au moins des valeurs échantillonnées de la tension d'alimentation, de l'intensité du courant électrique délivrés ou de la puissance instantanée délivrée ;
- des moyens de mémorisation et de lecture des valeurs successives du signal de consommation sur au moins une fenêtre d'observation ;
- des moyens d'application sur le signal de consommation, sur au moins une fenêtre d'observation courante, d'un traitement de filtrage par la méthode du Pencil, pour discriminer, sur ladite fenêtre, l'ensemble des pôles et résidus représentatifs d'une combinaison de signatures de charges électriques distinctes incluant au moins les pôles et les résidus associés à au moins une valeur singulière obtenue par la méthode du Pencil en fonctionnement dans l'installation ;
- des moyens de suivi temporel de ladite combinaison de signatures et de calcul, sur au moins la durée de la fenêtre d'observation courante, d'au moins la puissance active consommée par au moins un sous-ensemble des charges électriques en fonctionnement dans l'installation, exprimée comme la somme des puissances actives consommées par chaque charge électrique distincte de ce sous-ensemble vérifiant une fonction de puissance consommée liant lesdits pôles et résidus.

11. Dispositif selon la revendication 10, **caractérisé en ce que** lesdits moyens de suivi temporel de ladite combinaison de signatures et de calcul d'au moins la puissance active consommée par au moins un sous-ensemble des charges électriques comprennent :

- des modules séparés opérant sur les pôles, résidus, valeurs singulières de la composante d'intensité, de puissance respectivement de tension délivrée à l'installation ;
- un module de détection de changement d'état d'enclenchement/déclenchement de charge électrique ;
- un module d'identification des charges électriques enclenchées et/ou déclenchées à partir des signatures de charges électriques ;
- un module de librairie de charges électriques identifiées en relation avec leur signature ;
- un module d'identification des usages de consommation de l'utilisation abonné et de calcul de la consommation, au moins en puissance active.

12. Programme d'ordinateur mémorisé sur un support de mémorisation et exécutable par un ordinateur ou par l'unité centrale de traitement d'un dispositif dédié, ce programme d'ordinateur comportant une suite d'instructions permettant l'application d'un processus de suivi temporel de l'enclenchement/déclenchement de charges électriques selon l'une des revendications 1 à 7.

13. Programme d'ordinateur selon la revendication 12, **caractérisé en ce que** ledit programme d'ordinateur comporte au moins une routine de calcul de la puissance active consommée par chaque charge électrique distincte vérifiant une fonction de puissance consommée liant les pôles et les résidus du signal de consommation.

**Patentansprüche**

1. Verfahren zur eingriffsfreien Bestimmung der von einer Teilnehmeranlage verbrauchten elektrischen Leistung, wobei eine periodische Abtastung von Werten der Versorgungsspannung und der elektrischen Stromstärke, die dieser Anlage zugeführt werden, durchgeführt wird, um ein Verbrauchssignal zu erhalten, **dadurch gekennzeichnet, dass** dieses mindestens darin besteht, ausgehend von den Abtastwerten des Verbrauchssignals:

- die Abtastwerte auf aufeinanderfolgende Beobachtungszeitfenster zu gruppieren;
- auf jedem aufeinanderfolgenden aktuellen Beobachtungszeitfenster die Einheit der Pole ($S_i$) und der Residuen ($R_i$) des Verbrauchssignals durch das Pencil-Verfahren zu unterscheiden, wobei die Einheit von Polen und Residuen auf dem aktuellen Beobachtungsfenster für eine Kombination von verschiedenen Signaturen von elektrischen Lasten ($C_i$) repräsentativ ist, die mindestens bestimmte Pole ($S_i$) und Residuen ($R_i$) umfassen, die mit mindestens einem Singulärwert ($SG_i$) verbunden sind, der durch das Pencil-Verfahren erhalten wird, das in der Anlage in Betrieb ist;

- über mindestens die Dauer des aktuellen Beobachtungsfensters mindestens die Wirkleistung, die von mindestens einer Untereinheit der elektrischen Lasten verbraucht wird, die in der Anlage in Betrieb sind, ausgedrückt als die Summe der Wirkleistungen, die von jeder verschiedenen elektrischen Last dieser Untereinheit verbraucht werden, zu berechnen, die eine Funktion der verbrauchten Leistung überprüft, die die Pole und Residuen verbindet.

2. Verfahren nach Anspruch 1, **dadurch gekennzeichnet, dass** die Funktion für die Wirkleistung die Beziehung überprüft:

$$P = \sum_{i=1}^{M} \sum_{i'=1}^{M'} R_{ci} R_{vi'} e^{(S_{ci}+S_{vi'})\left(t_{kd}+\frac{\Delta t}{2}\right)} \cdot \sinh c\left((S_{ci}+S_{vi'})\frac{\Delta t}{2}\right)$$

wobei $P$: die Wirkleistung bezeichnet, die von der Einheit der verschiedenen elektrischen Lasten $C_i$ der Signatur $(S_i, R_i, SG_i)$ verbraucht wird;

$S_{ci}$ und $R_{ci}$: die jeweiligen Pole der Residuen des abgetasteten Stroms bezeichnen, der an die Anlage abgegeben wird;

$S_{vi'}$ und $R_{vi'}$: die jeweiligen Pole der Residuen der abgetasteten Spannung bezeichnen, die an die Anlage abgegeben wird,

wobei $SG_i$ die Singulärwerte bezeichnet;

$t_{kd}$: den Zeitpunkt des Beginns des Beobachtungsfensters des Rangs $k$ bezeichnet;

$\Delta t$: die Dauer des Beobachtungsfensters bezeichnet; $\sinh c(X)$: die hyperbolische Sinusfunktion des Kardinals des Wertes X

$$\sinh c\left((S_{ci}+S_{vi'})\frac{\Delta t}{2}\right) = \sinh\left((S_{ci}+S_{vi'})\frac{\Delta t}{2}\right) \bigg/ \left((S_{ci}+S_{vi'})\frac{\Delta t}{2}\right)$$

ist;

$M$: die Anzahl an Polen und Residuen des abgetasteten Stroms bezeichnet, der an die Anlage abgegeben wird;

$M'$: die Anzahl an Polen und Residuen der abgetasteten Spannung bezeichnet, die an die Anlage abgegeben wird.

3. Verfahren nach Anspruch 1 oder 2, **dadurch gekennzeichnet, dass** für eine im Wesentlichen periodische Versorgungsspannung der Pulsation $\omega$ und der Periode T die Dauer $\Delta t$ von jedem aktuellen Beobachtungsfenster gleich der Periode genommen wird.

4. Verfahren nach einem der Ansprüche 1 bis 3, **dadurch gekennzeichnet, dass** die Abtastfrequenz, um das Verbrauchssignal zu erhalten, und die Dauer $\Delta t$ von jedem Beobachtungsfenster durch die Beziehung:

$$\Delta t \cdot fe = Nem \geq 2 \cdot \left[\sum_{i=1}^{Nc} nci + 2(1+H)\right]$$

verbunden werden, worin:

$fe$: die Abtastfrequenz bezeichnet;

$Nem$: die Mindestanzahl von Abtastungen über die Dauer jedes Beobachtungsfensters bezeichnet;

$Nc$: die beobachtete Anzahl von verschiedenen elektrischen Lasten ($C_i$) der Teilnehmeranlage bezeichnet;

$nci$: die Anzahl von Polen der elektrischen Last ($C_i$) bezeichnet;

$H$: die Anzahl von harmonischen Komponenten der Grundfrequenz der Versorgungsspannung bezeichnet.

**5.** Verfahren nach einem der Ansprüche 1 bis 4, **dadurch gekennzeichnet, dass** nach dem Schritt des Unterscheidens der Einheit der Pole $(S_i)$ und der Residuen $(R_i)$ des Verbrauchssignals dieses ferner einen Schritt des Unterscheidens und des Erfassens der Signaturen aufweist, die durch ein Polpaar $(S_i)$, Residuen $(R_i)$ von jeder verschiedenen elektrischen Last $(C_i)$ und den Singulärwerten $(SG_i)$ gebildet werden.

**6.** Verfahren nach Anspruch 5, **dadurch gekennzeichnet, dass** das Verfahren nach dem Erfassen der Signaturen $(S_i, R_i, SG_i)$ einen Schritt des Identifizierens der elektrischen Lasten aufweist, die die Untereinheit von verschiedenen elektrischen Lasten im Betrieb auf mindestens einem Beobachtungsfenster bilden.

**7.** Verfahren nach Anspruch 5 oder 6, **dadurch gekennzeichnet, dass** das Verfahren nach dem Erfassen der Signaturen $(S_i, R_i, SG_i)$ einen Schritt des Überwachens des Betriebs/des außer Betrieb Setzens jeder einzelnen Last durch Unterscheiden der gesamten oder eines Teils der Signatur auf mindestens einem Beobachtungsfenster aufweist.

**8.** Verfahren nach einem der Ansprüche 6 oder 7, **dadurch gekennzeichnet, dass** für ein Beobachtungsfenster des Verbrauchssignals, das den freien Betriebszustand und den Beginn des Zwangsbetriebszustands des Einschaltens/Ausschaltens einer Last umfasst,

- das Einschalten/Ausschalten einer rein ohmschen Last durch einen einzigen Zwangsbetriebszustand, durch die Existenz für das Beobachtungsfenster von zwei konjugiert-komplexen Polen mit einem Realteil, der gleich Null ist, und zwei konjugiert-komplexen Residuen im Zwangsbetriebszustand und durch die Nullphase der Residuen im Zwangsbetriebszustand signiert wird;
- das Einschalten/Ausschalten einer ohmschen und kapazitiven Last durch einen freien Betriebszustand und einen Zwangsbetriebszustand, die verschieden sind, durch die Existenz für das Beobachtungsfenster von zwei konjugiert-komplexen Polen mit einem Realteil, der gleich Null ist, und zwei konjugiert-komplexen Residuen im Zwangsbetriebszustand und durch einen Realpol und ein Residuum im freien Betriebszustand signiert wird, wobei die negative Phase des Residuums im Zwangsbetriebszustand die im Allgemeinen kapazitive Art der Last kennzeichnet;
- das Einschalten/Ausschalten einer rein ohmschen und induktiven Last durch einen freien Betriebszustand und einen Zwangsbetriebszustand, die verschieden sind, durch die Existenz für das Beobachtungsfenster von zwei konjugiert-komplexen Polen mit einem Realteil, der gleich Null ist, und zwei konjugiert-komplexen Residuen im Zwangsbetriebszustand und durch einen Realpol und ein komplexes Residuum im freien Betriebszustand signiert wird, wobei die positive Phase des Residuums die im Allgemeinen induktive Art der Last kennzeichnet.

**9.** Verfahren nach einem der Ansprüche 6 oder 7, **dadurch gekennzeichnet, dass** für ein Beobachtungsfenster des Verbrauchssignals, das den freien Betriebszustand und den Beginn des Zwangsbetriebszustands des Einschaltens/Ausschaltens einer Last umfasst, das Einschalten/Ausschalten einer ohmschen, induktiven und kapazitiven Last durch einen Zwangsbetriebszustand und einen freien Betriebszustand, die verschieden sind, durch die Existenz:

- im Zwangsbetriebszustand von zwei konjugiert-komplexen Polen mit einem Realteil, der gleich Null ist, und zwei konjugiert-komplexen Residuen und
- im freien Betriebszustand von zwei konjugiert-komplexen Polen und zwei konjugiert-komplexen Residuen signiert wird, wobei die negative Phase des Residuums im Zwangsbetriebszustand die im Allgemeinen kapazitive Art der Last kennzeichnet und die positive Phase des Residuums im Zwangsbetriebszustand die im Allgemeinen induktive Art der Last kennzeichnet.

**10.** Vorrichtung zur eingriffsfreien Bestimmung der von einer Teilnehmeranlage verbrauchten elektrischen Leistung, umfassend mindestens Mittel zur periodischen Abtastung von Werten der Versorgungsspannung und der elektrischen Stromstärke, die dieser Anlage zugeführt werden, um ein Verbrauchssignal zu erhalten, **dadurch gekennzeichnet, dass** die Vorrichtung ferner mindestens aufweist:

- Mittel zum Berechnen der abgegebenen Momentanleistung aus den Abtastwerten der Werte der Versorgungsspannung und der elektrischen Stromstärke, die zugeführt sind, wobei das Verbrauchssignal mindestens einen der Abtastwerte der Versorgungsspannung, der elektrischen Stromstärke, die zugeführt sind, oder der abgegebenen Momentanleistung aufweist;
- Mittel zum Speichern und zum Lesen der aufeinanderfolgenden Werte des Verbrauchssignals auf mindestens einem Beobachtungsfenster;
- Mittel zum Anwenden auf das Verbrauchssignal auf mindestens einem aktuellen Beobachtungsfenster von einer Filterbearbeitung durch das Pencil-Verfahren, um auf dem Beobachtungszeitfenster die Einheit der jeweiligen Pole und Residuen zu unterscheiden, die für eine Kombination von verschiedenen Signaturen von elektrischen Ladungen repräsentativ sind, die mindestens die Pole und die Residuen umfassen, die mit mindestens einem Singulärwert verbunden sind, der durch das Pencil-Verfahren erhalten ist, das in der Anlage in Betrieb ist;
- Mittel zum zeitlichen Überwachen der Kombination von Signaturen und zum Berechnen über mindestens die Dauer des aktuellen Beobachtungsfensters mindestens der Wirkleistung, die von mindestens einer Untereinheit der elektrischen Lasten verbraucht wird, die in der Anlage in Betrieb sind, ausgedrückt als die Summe der Wirkleistungen, die von jeder verschiedenen elektrischen Last dieser Untereinheit verbraucht werden, die eine Funktion der verbrauchten Leistung überprüft, die die Pole und Residuen verbindet.

**11.** Vorrichtung nach Anspruch 10, **dadurch gekennzeichnet, dass** die Mittel zum zeitlichen Überwachen der Kombination von Signaturen und zum Berechnen mindestens der Wirkleistung, die von mindestens einer Untereinheit der elektrischen Lasten verbraucht wird, aufweisen:

- separate Module, die an den Polen, Residuen, Singulärwerten der Komponenten jeweils der Stärke, der Leistung, die der Anlage zugeführt werden, einwirken;
- ein Modul zum Erfassen der Änderung des Zustands des Einschaltens/Ausschaltens einer elektrischer Last;
- ein Modul zum Identifizieren der elektrischen Lasten, die von den Signaturen elektrischer Lasten eingeschaltet und/oder ausgeschaltet werden;
- ein Bibliothek-Modul von elektrischen Lasten, die in Verbindung mit ihrer Signatur identifiziert werden;
- ein Modul zum Identifizieren der Verbrauchsnutzungen der Teilnehmerverwendung und zum Berechnen des Verbrauchs mindestens in Wirkleistung.

**12.** Computerprogramm, das auf einem Speichermedium gespeichert ist und von einem Computer oder der zentralen Verarbeitungseinheit einer dedizierten Vorrichtung ausführbar ist, wobei dieses Computerprogramm eine Folge von Anweisungen aufweist, die die Anwendung eines Verfahrens zum zeitlichen Überwachen des Ein-/ Ausschaltens von elektrischen Lasten nach einem der Ansprüche 1 bis 7 ermöglicht.

**13.** Computerprogramm nach Anspruch 12, **dadurch gekennzeichnet, dass** das Computerprogramm mindestens eine Berechnungsroutine der Wirkleistung aufweist, die von jeder verschiedenen elektrischen Last verbraucht wird, die eine Funktion der verbrauchten Leistung überprüft, die die Pole und Residuen des Verbrauchssignals verbindet.

**Claims**

**1.** Method for non-intrusive determination of the electrical power consumed by a subscriber installation, in which periodic sampling of the values of supply voltage and of electric current intensity delivered to said installation is undertaken in order to obtain a consumption signal, **characterized in that** the latter consists at least, based on the sampled values of the consumption signal, of:

- grouping said values sampled in successive observation time windows;
- discriminating in each successive current observation time window the set of poles ($S_i$) and of residues ($R_i$) of the consumption signal by the Pencil method, said set of poles and residues being representative, in the current observation window, of a combination of signatures of separate electrical loads ($C_i$) including at least defined poles ($S_i$) and residues ($R_i$) associated with at least one singular value ($SG_i$) obtained by the Pencil method in operation in said installation;
- calculating, for at least the duration of said current observation window, at least the active power consumed by at least one subset of the electrical loads in operation in the installation, expressed as the sum of the active powers consumed by each separate electrical load of said subset complying with a consumed power function linking said poles and residues.

**2.** Method according to claim 1, **characterized in that**, for said active power, said function complies with the relation:

$$P = \sum_{i=1}^{M} \sum_{i'=1}^{M'} R_{ci.} R_{vi'}.e^{\left(S_{ci}+S_{vi'}\right)\left(t_{kd} + \frac{\Delta t}{2}\right)} . \sinh c\left(\left(S_{ci} + S_{vi'}\right)\frac{\Delta t}{2}\right)$$

where $P$: denotes the active power consumed by the set of separate electrical loads $C_i$ of signature $(S_i, R_i, SG_i)$;

$S_{ci}$ and $R_{ci}$: denote the poles and respectively the residues of the sampled current delivered to the installation;

$S_{vi'}$ and $R_{vi'}$: denote the poles and respectively the residues of the sampled voltage delivered to the installation, $SGi$ denoting the singular values;

$t_{kd}$: denotes the start time of the observation window of rank $k$;

$\Delta t$: denotes the duration of the observation window;

sinh $c(X)$: the hyperbolic sine function of the cardinal of the value X, i.e.

$$\sinh c\left(\left(S_{ci} + S_{vi'}\right)\frac{\Delta t}{2}\right) = \sinh\left(\left(S_{ci} + S_{vi'}\right)\frac{\Delta t}{2}\right) \bigg/ \left(\left(S_{ci} + S_{vi'}\right)\frac{\Delta t}{2}\right);$$

$M$: denotes the number of poles and residues of the sampled current delivered to the installation;

$M'$: denotes the number of poles and residues of the sampled voltage delivered to the installation.

3. Method according to claim 1 or 2, **characterized in that** for a roughly periodic supply voltage of angular frequency $\omega$ and of period T, the duration $\Delta t$ of each current observation window is taken as equal to said period.

4. Method according to one of claims 1 to 3, **characterized in that** the sampling frequency for obtaining said consumption signal and said duration $\Delta t$ of each observation window are linked by the relation:

$$\Delta t .fe = Nem \geq 2.\left[\sum_{i=1}^{Nc} nci + 2\left(1 + H\right)\right]$$

in which:

$fe$: denotes the sampling frequency;

$Nem$: denotes the minimum number of samples for the duration of each observation window;

$Nc$: denotes the observed number of separate electrical loads $(C_i)$ of the subscriber installation;

$nci$: denotes the number of poles of the electrical load $(C_i)$;

$H$: denotes the number of harmonic components of the fundamental frequency of the supply voltage.

5. Method according to one of claims 1 to 4, **characterized in that**, following the stage consisting of discriminating the set of poles $(S_i)$ and of residues $(R_i)$ of the consumption signal, the latter further comprises a stage of discrimination and of acquisition of the signatures formed by a pair of poles $(S_i)$, residues $(R_i)$ of each separate electrical load $(C_i)$ and of the singular values $(SG_i)$.

6. Method according to claim 5, **characterized in that**, following acquisition of said signatures $(S_i, R_i, SG_i)$ said method comprises a stage for identifying said electrical loads constituting said subset of separate electrical loads in operation in at least one observation window.

7. Method according to claim 5 or 6, **characterized in that**, following acquisition of said signatures $(Si, Ri, SGi)$, said method comprises a stage of tracking of the switching on/off of each separate load, by discrimination of all or part of the signature in at least one observation window.

8. Method according to one of claims 6 or 7, **characterized in that**, for an observation window of the consumption signal including the free regime and the beginning of the forced regime of connection/disconnection of a load,

- the connection/disconnection of a purely resistive load is signified by a unique forced regime, by the existence, for the observation window, of two conjugated complex poles with a zero real part and of two conjugated complex residues in the forced regime, and by zero phase of the residues in the forced regime;
- the connection/disconnection of a resistive and capacitive load is signified by a separate free regime and a separate forced regime, the existence, for the observation window, of two conjugated complex poles with a zero real part and of two conjugated complex residues in the forced regime and by a real pole and a residue in the free regime, the negative phase of the residue in forced regime characterizing the overall capacitive nature of the load;
- the connection/disconnection of a resistive and inductive load is signified by a separate free regime and a separate forced regime, by the existence, for the observation window, of two conjugated complex poles with a zero real part and of two conjugated complex residues in the forced regime and by a real pole and a complex residue, in the free regime, the positive phase of the residue characterizing the overall inductive nature of the load.

9. Method according to one of claims 6 or 7, **characterized in that**, for an observation window of the consumption signal including the free regime and the start of the forced regime of connection/disconnection of a load, the connection/disconnection of a resistive, inductive and capacitive load is signified by a separate forced regime and a separate free regime, by the existence:

- in forced regime, of two conjugated complex poles with a zero real part and two conjugated complex residues; and,
- in free regime, of two conjugated complex poles and two conjugated complex residues, the negative phase of the residue in the forced regime characterizing the overall capacitive nature of the load and the positive phase of the residue in the forced regime characterizing the overall inductive nature of the load.

10. Device for non-intrusive determination of the electrical power consumed by a subscriber installation, having at least means for periodic sampling of the values of supply voltage and of the electric current intensity delivered to said installation for obtaining a consumption signal, **characterized in that** said device further comprises at least:

- means for calculating the instantaneous power delivered, the product of the sampled values of the values of supply voltage and of the electric current intensity delivered, said consumption signal having at least one of the sampled values of the supply voltage delivered, the electric current intensity delivered or the instantaneous power delivered;
- means for storing and reading the successive values of the consumption signal in at least one observation window;
- means for application, on the consumption signal, in at least one current observation window, of a filtering treatment by the Pencil method, for discriminating, in said window, the set of poles and residues representative of a combination of signatures of separate electrical loads including at least the poles and the residues associated with at least one singular value obtained by the Pencil method in operation in the installation;
- means for temporal tracking of said combination of signatures and for calculating, for at least the duration of the current observation window, at least the active power consumed by at least one subset of the electrical loads in operation in the installation, expressed as the sum of the active powers consumed by each separate electrical load of this subset complying with a consumed power function linking said poles and residues.

11. Device according to claim 10, **characterized in that** said means for temporal tracking of said combination of signatures and for calculating at least the active power consumed by at least one subset of the electrical loads comprise:

- separate modules operating on the poles, residues, singular values of the component of intensity, of power or of voltage delivered to the installation;
- a module for detecting change of state of connection/disconnection of electrical load;
- a module for identifying the connected and/or disconnected electrical loads from the signatures of electrical loads;
- a library module of electrical loads identified in relation to their signature;
- a module for identifying the consumption usages of the subscriber use and for calculating the consumption, at least of active power.

12. Computer program stored on a storage medium and executable by a computer or by the central processing unit of a dedicated device, this computer program having a sequence of instructions permitting the application of a process of temporal tracking of the connection/disconnection of electrical loads according to one of claims 1 to 7.

13. Computer program according to claim 12, **characterized in that** said computer program comprises at least one routine for calculating the active power consumed by each separate electrical load complying with a consumed power function linking the poles and residues of the consumption signal.

## FIG. 1a

$$\{V_x, I_x\}_1^{KN}$$
fe

**A** — Groupement

$$\{V_x, I_x\}_1^{KN} \xrightarrow{\Delta t} [V_{kj}, P_{kj}, I_{kj}]_{k=1\ j=1}^{k=K\ j=N}$$

**B** — Méthode du Pencil

$$P\ [V_{kj}, P_{kj}, I_{kj}]_{k=1\ j=1}^{k=K\ j=N} \longrightarrow [(S_i, R_i, SG_i)_{i=1}^{i=N_c}]_{k=1}^{k=K}$$

**C** — Calcul de puissance

$$P = \sum_{i=1}^{i=M} \sum_{i'=1}^{i'=M'} R_{ci} \cdot R_{vi'} \cdot e^{(S_{ci}+S_{vi'})(t_{kd}+\frac{\Delta t}{2})} \cdot \text{sinhc}\ ((S_{ci}+S_{vi'})\frac{\Delta t}{2})$$

## FIG. 1b

fe

**A1** — Choix $\Delta t\,|\,fe$

$$\Delta t \cdot fe \geq Nem = 2 \cdot [\sum_{i=1}^{Nc} nc_i + 2\ (1+H)]$$

**A2** — Groupement

**FIG. 2a**

**FIG. 2b**

$$\{c_i\}_{i=1}^{i=Nc}$$

$$\exists \mathscr{S}_i \Longleftrightarrow c_i \quad ?$$

300

302

$$i = i + 1$$

301

$$c_i = \text{``ON''}$$

303

$$c_i = \text{``OFF''}$$

**FIG. 2c**

FIG. 3a

FIG. 3b

FIG. 3c

Coefficients d'amplifications des pôles (Np/s)

FIG. 3d

Fréquence des pôles (Hz)

FIG. 3e

**FIG. 3f**

FIG. 3g

FIG. 4a

FIG.4b

De $4_1$ → Changement d'état ($4_4$) → Identification éléments ($4_5$) → Identification Usage Consommation ($4_7$)

De $4_2$ →

De $4_3$ →

LIBRAIRIE ($4_6$)

$4$

EP 2 338 064 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4858141 A
- US 5483153 A
- FR 2645968
- US 6816078 B
- EP 1136829 A
- US 7078982 B2
- WO 9304377 A

**Littérature non-brevet citée dans la description**

- **A.COLE ; A. ALBICKI.** Data Extraction for Effective Non-Intrusive Identification of Residential Power Loads. *IEEE Instrumentals and Measurement technology conference,* Mai 1998
- NON-INTRUSIVE. **ROOS JG.** LOAD MONITORING OF ELECTRICAL APPLIANCES. ELEKTRON Verlag, 01 Avril 1994
- Generalized Pencil-of-Function Method for Extracting Poles of an EM System from its Transient Response. **YINGBO HUA ; TAPAN K. SARKAR.** IEEE TRANSACTIONS ON ANTENNAS AND PROPAGATION. Department of Electrical and Computer Engineering, Syracuse University, Février 1989, vol. 37, 229-234
- **ZHO Y et al.** Spectral estimation of two-dimensional, NMR Signals by matrix pencil method. *PROCEEPINGS OF THE REGION TEN CONFERENCE (TENCON),* 19 Octobre 1993
- Comparison between the Matrix Pencil Method and the Fourier Transform Technique for High Resolution Spectral Estimation. **JOSÉ ENRIQUE FERNANDEZ DEL RIO ; TAPAN K. SARKAR.** Digital Signal Processing. Department of Electrical and Computer Engineering, 121 Link Hall, Syracuse University, 1996, vol. 6, 108-125